# EUROPEAN PATENT APPLICATION

(11) **EP 1 865 540 A1**
(43) Date of publication of application: **12.12.2007**
(21) Application number: 06730625.8
(22) Date of filing: 30.03.2006
(51) Int. Cl.: H01L 21/027, G03F 7/20

(54) **EXPOSURE APPARATUS, EXPOSURE METHOD, AND DEVICE PRODUCING METHOD**

(30) Priority: 30.03.2005 JP 2005098051
(71) Applicant: NIKON CORPORATION, Tokyo 100-8331 (JP)
(72) Inventor: NAKANO, Katsushi, c/o NIKON CORPORATION, Tokyo 1008331 (JP); HAMATANI, Masato, c/o NIKON CORPORATION, Tokyo 1008331 (JP)
(74) Representative: Hooiveld, Arjen Jan Winfried
(86) International application number: PCT/JP2006/306677
(87) International publication number: WO 2006/106833

(57) **Abstract**

An exposure apparatus (EX) includes: a substrate stage (ST1) that is movable while holding substrate (P); a first immersion mechanism (1) that fills an optical path space (K1) between a final optical member (LS1) and the substrate stage (ST1) with a liquid (LQ) when the substrate stage (ST1) is disposed opposite the final optical member (LS1) that is closest to the image plane of the projection optical system (PL); a measurement stage (ST2) in which the optical path space (K1) with the final optical member (LS1) is filled with the liquid (LQ) when the measurement stage (ST2) is disposed in place of the substrate stage (ST1) opposite the final optical member (LS1) in the projection optical system; a measuring device (60) that has an upper plate (65) that is disposed on the measurement stage (ST2), and that carries out specific measurements when the upper plate (65) is disposed opposite the final optical member (LS1) of the projection optical system with the liquid (LQ) held therebetween; and a second immersion mechanism (2) that forms an immersion region (LR2) on the upper plate (65) at least when the measurement stage (ST2) has moved away from the final optical member (LS1) in the projection optical system.

## Description

### TECHNICAL FIELD

The present invention relates to an exposure apparatus and exposure method for exposing a substrate via a liquid, and to a device manufacturing method.
Priority is claimed on Japanese Patent Application No. 2005-098051, filed March 30, 2005, the content of which is incorporated herein by reference.

### BACKGROUND ART

In a photolithography process, which is one manufacturing process for micro devices (electronic devices etc.) such as semiconductor devices, liquid crystal displays and the like, an exposure apparatus is used which projects and exposes a pattern that is formed on a mask onto a photosensitive substrate. This exposure apparatus has a movable mask stage for holding the mask, and a movable substrate stage for holding a substrate, and the mask pattern is projected and exposed onto the substrate via a projection optical system as the mask stage and the substrate stage are gradually moved. In the manufacture of a micro device, in order to increase the density of the device, it is necessary to make the pattern formed on the substrate fine. In order to address this necessity, even higher resolution of the exposure apparatus is desired. As one means for realizing this higher resolution, there is proposed a liquid immersion exposure apparatus as disclosed in Patent Reference Document 1 noted below, in which the space in the optical path of the exposure light is filled with a liquid, and exposure light is shone onto the substrate via the liquid, to thereby expose the substrate.
[Patent Reference Document 1] PCT International Patent Publication No. WO 99/49504

### DISCLOSURE OF INVENTION

### PROBLEMS TO BE SOLVED BY THE INVENTION

However, in a liquid immersion exposure apparatus, when the substrate stage is moved from below the projection optical system, and conversion from a wet to a dry state is carried out by recovering the liquid in the optical path space on the image plane side of the projection optical system, the liquid may leave a residue on the surface of the last optical element (i.e., the optical element nearest the image plane) of the projection optical system that is in contact with the liquid (note that hereinafter, a liquid residue will be referred to as a "water mark," this including the case where the liquid is not water). Moreover, there is also a concern that the final optical element will undergo thermal deformation due to the heat of vaporization when any liquid adhering to the surface of the final optical element of the projection optical system dries. The occurrence of water marks or thermal deformation of the final optical element of the projection optical system may cause a deterioration in the optical performance of the projection optical system and lead to a deterioration in the performance of the exposure apparatus.
The present invention was conceived in view of the above-described circumstances and has as its objective the provision of an exposure apparatus and a device manufacturing method with which it is possible to prevent a deterioration in the performance of the apparatus even when carrying out the exposure process using a liquid.

### MEANS FOR SOLVING THE PROBLEM

In order to resolve the above problems, the present invention employs the following structure corresponding to various figures showing the preferred embodiments of the present invention. However, the symbols in parenthesis that are associated with each of the compositional elements are merely intended to indicate the elements and are not limitations thereon.
According to a first aspect of the present invention, there is provided an exposure apparatus (EX) that exposes a substrate (P) via an optical element (PL, LS1) and a liquid (LQ), that includes: a substrate holding member (ST1) that is movable while holding substrate (P); a first immersion mechanism (1) which fills a space (K1) between the optical element (PL, LS1) and the substrate holding member (ST1) with a liquid (LQ); a movable member (ST2) which can be disposed in place of the substrate holding member (ST1) opposite the optical element (PL, LS1) while retaining with the optical element (PL, LS1) the liquid (LQ) therebetween; a measuring device (60,RA) that has a measuring member (65, FM) which is disposed on the movable member (ST2), and which carries out a specific measurement when the measuring member (65, FM) is disposed by placing the movable member (ST2) opposite the optical element (PL,LS1) with the liquid (LQ) held therebetween; and a second immersion mechanism (2) that forms an immersion region (LR2) on the measuring member (65, FM) at least when the movable member (ST2) has moved away from the optical element (PL,LS1).
In the first aspect of the present invention, the movable member is disposed opposite the optical element even when the substrate holding member has moved away from the optical element. As a result, it is not only possible to continue filling the optical path in the space between the member and the optical element with liquid, but also to carry out specific measurements using the measuring members that are disposed on this movable member. Further, when this movable member moves away from the optical element, it is possible to form an immersion region on top of the measuring members that are disposed on top of the movable member. Accordingly, it is possible to prevent formation of water marks on or thermal deformation of the measuring members. As a result, it is possible to prevent a deterioration in the measurement performance of a measuring device employing these measuring members.
According to a second aspect of the present invention, there is provided an exposure apparatus that exposes a substrate (P) via an optical element (PL, LS1) and liquid (LQ), that includes: a first movable member (ST1) that holds a substrate (P); a first immersion mechanism (1) that forms a first immersion region (LR1) by filling a space (K1) between the optical element (PL, LS1) and the first movable member (ST1) with a liquid (LQ); a second movable member (ST2) that can be disposed in place of the first movable member (ST1) opposite the optical element (PL, LS1) while retaining with the optical element (PL, LS1) the first immersion region (LR1) therebetween, and that has a measuring member (65, FM) within the surface of contact (59) with the liquid (LQ); and a second immersion mechanism (2) that forms a second immersion region (LR2) on the measuring member (65, FM) that is in contact with the liquid (LQ) at a different position from that of the first immersion mechanism (1). By means of this second aspect of the present invention, it is possible to prevent a decrease in the accuracy of measurements using the measuring member.
According to a third aspect of the present invention, there is provided a device manufacturing method that uses the exposure apparatus (EX) according to the abovementioned aspects. By means of this third aspect, it is possible to produce a device that demonstrates the desired performance using the above-described exposure apparatus.
According to a fourth aspect of the present invention, there is provided an exposure method for exposing a substrate (P) via an optical element (PL, LS1) and a liquid (LQ), comprising: forming a first liquid immersion region (LR1) by filling a space (K1) between the optical element (PL, LS1) and a first movable member (ST1) which is holding the substrate (P) with a liquid (LQ), and exposing the substrate (P) via the optical element (PL, LS1) and the liquid (LQ); disposing a second movable member (ST2) in place of the first movable member (ST1) opposite the optical element (PL, LS1) while maintaining with the optical element (PL, LS1) the first immersion region (LR1) therebetween; and forming a second immersion region (LR2) on top of a measuring member (65, FM) after the measuring member (65, FM) of the second movable member (ST2) has come into contact with the liquid (LQ). As a result of the fourth aspect of the present invention, it is possible to prevent a decrease in the accuracy of measurements using the measuring members.
The fifth aspect of the present invention provides a device manufacturing method using the exposure method of the above embodiment. As a result of the fifth embodiment, it is possible to manufacture a device using this exposure method that can prevent a decline in the accuracy of measurements using the measuring member.

### EFFECTS OF THE INVENTION

In accordance with the present invention, it may be possible to reliably remove liquid adhered to a substrate that has been exposed through the liquid.

### BRIEF DESCRIPTION OF THE DRAWINGS

FIG. 1 is a schematic view of an exposure apparatus according to the first embodiment.
FIG. 2 is a view for explaining one example of the operation of the exposure apparatus.
FIG. 3 is a plan view of the substrate stage and the measurement stage as seen from above.
FIG. 4 is a view showing an example of the measuring device provided to the measurement stage.
FIG. 5 is a schematic perspective view showing the second immersion mechanism according to the first embodiment.
FIG. 6 is a view for explaining an example of the operation of the exposure apparatus.
FIG. 7 is a view for explaining an example of the operation of the exposure apparatus.
FIG. 8 is a view for explaining an example of the operation of the exposure apparatus.
FIG. 9 is a view for explaining an example of the operation of the exposure apparatus.
FIG. 10 is a view for explaining an example of the operation of the exposure apparatus.
FIG. 11 is a schematic perspective view showing the second immersion mechanism according to the second embodiment.
FIG. 12 is a view for explaining an example of the operation of the second immersion mechanism according to the second embodiment.
FIG. 13 is a view for explaining an example of the operation of the second immersion mechanism according to the second embodiment.
FIG. 14A is a view showing the second immersion mechanism according to the third embodiment.
FIG. 14B is a view showing the second immersion mechanism according to the third embodiment.
FIG. 15A is a view showing the second immersion mechanism according to the fourth embodiment.
FIG. 15B is a view showing the second immersion mechanism according to the fourth embodiment.
FIG. 16 is a flow chart diagram for explaining an example of the manufacturing steps for a micro device.

### DESCRIPTION OF THE REFERENCE SYMBOLS

1...FIRST IMMERSION MECHANISM, 2...SECOND IMMERSION MECHANISM, 32...LIQUID SUPPLY PORT, 44...LIQUID COLLECTION GROOVE, 46...RECESS PORTION, 60...SPATIAL IMAGE MEASURING SENSOR (MEASURING DEVICE), 61... SLIT (MEASUREMENT PATTERN, LIGHT TRANSMITTING PART), 65...UPPER PLATE (MEASURING MEMBER), 70...FIRST NOZZLE MEMBER, 72...SECOND NOZZLE MEMBER, EL...EXPOSURE LIGHT, EX ... EXPOSURE APPARATUS, FM...REFERENCE MARK PLATE (MEASURING MEMBER), FM1, FM2...REFERENCE MARK (MEASURING PATTERN), K1 ... OPTICAL PATH SPACE, LR1...IMMERSION REGION, LR2...IMMERSION REGION, LQ...LIQUID, LS1...FINAL OPTICAL COMPONENT (OPTICAL ELEMENT), P...SUBSTRATE, PJ...RETRACTED POSITION, PL...PROJECTION OPTICAL SYSTEM (OPTICAL ELEMENT), RP...SUBSTRATE EXCHANGE POSITION, ST1...SUBSTRATE STAGE (SUBSTRATE HOLDING MEMBER), ST2...MEASUREMENT STAGE (MOVABLE MEMBER)

### BEST MODE FOR CARRYING OUT THE INVENTION

Hereunder is a description of embodiments of the present invention with reference to the drawings. However, the present invention is not limited to this description.

### <First Embodiment>

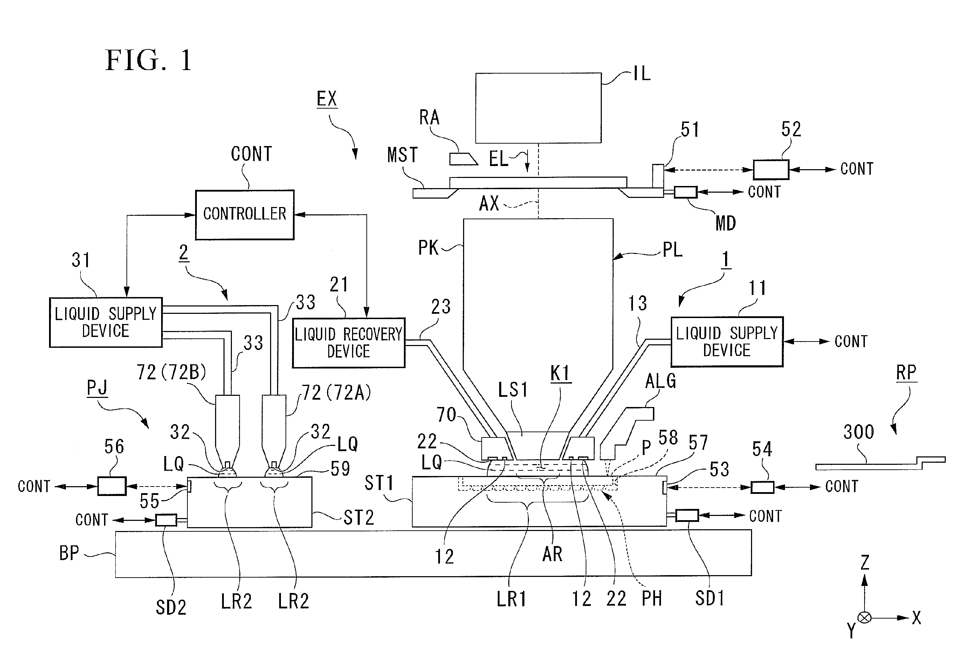

A first embodiment of the exposure apparatus according to the present invention will now be explained with reference to FIG. 1. FIG. 1 is a schematic compositional view showing the exposure apparatus EX according to the first embodiment.

In FIG. 1, the exposure apparatus EX includes: a mask stage MST capable of moving while holding a mask M; a substrate stage ST1 that is capable of moving and holds a substrate P using a substrate holder PH; a measurement stage ST2 that is capable of moving and mounts at least part of the measuring device that carries out measurements related to exposure; an illumination optical system IL that illuminates the mask M on top of the mask stage MST with exposure light EL; a projection optical system PL that projects the pattern image of the mask M illuminated by exposure light EL onto substrate P on top of the substrate stage ST1; and a controller CONT which provides unifying control of all of the operations of the exposure apparatus EX. The substrate stage ST1 and the measurement stage ST2 are each capable of independent movement on top of a base member BP on the image plane side of the projection optical system. Further, exposure apparatus EX is provided with a conveying apparatus 300 that conveys the substrate P, i.e., loads substrate P onto substrate stage ST1, and unloads substrate P from substrate stage ST1. Note that while loading and unloading of substrate P may be carried out at different positions, in this embodiment, loading and unloading of substrate P is carried out at the same position (RP).

The exposure apparatus EX of the present embodiment is a liquid immersion exposure apparatus applicable to an immersion method for substantially shortening the exposure length and improving the resolution, and also substantially expanding the depth of focus. It includes: a first immersion mechanism 1 for filling the optical path space K1 of the exposure light EL on the image plane side of a projection optical system PL with a liquid LQ. The first immersion mechanism 1 includes: a first nozzle member 70 that is provided in the vicinity of the image plane side of the projection optical system PL and that has supply ports 12 for supplying the liquid LQ and collection ports 22 for recovering the liquid LQ; a liquid supply device 11 that supplies the liquid LQ to a supply pipe 13 and to the image plane side of the projection optical system PL via the supply ports 12 provided in the first nozzle member 70; and a liquid recovery device 21 that recovers the liquid LQ on the image plane side of the projection optical system PL via the collection ports 22 and a recovery pipe 23 provided in the first nozzle member 70. The first nozzle member 70 is formed in an annular shape so as to surround from among the plurality of optical elements constituting the projection optical system PL, at least the final optical element LS1 that is nearest the image plane of the projection optical system PL.

The exposure apparatus EX adopts a local liquid immersion method for locally forming an immersion region LR1 of the liquid LQ that is larger than the projection region AR and smaller than the substrate P, to a part of the substrate P that includes the projection region AR of the projection optical system PL. The exposure apparatus EX uses the first immersion mechanism 1 to fill, with the liquid LQ, the optical path space K1 of the exposure light EL between the final optical element LS 1 nearest the image plane of the projection optical system PL and the substrate P disposed at the image plane side of the projection optical system PL, at least while the pattern image of the mask M is being projected on the substrate P. The exposure apparatus EX then irradiates the substrate P with exposure light EL that has passed through the mask M via the projection optical system PL and the liquid LQ filling the optical path space K1, projecting and exposing the pattern of the mask M onto the substrate P. The exposure light EL incidents onto the projection optical system PL from the optical element that is closest to the object plane of the projection optical system PL on which the pattern surface (bottom surface in FIG. 1) of the mask M is disposed, and is emitted out from the final optical element LS1 that is closest to the image plane of the projection optical system PL. Accordingly, the optical path space K1 of the exposure light EL between the final optical element LS1 and the substrate P is the space on the light emission side of the final optical element LS1. The first immersion mechanism 1 fills the optical path space K1 on the side of light emission from the final optical element LS1 with liquid LQ. The controller CONT fills the optical path space K1 with liquid LQ by using the liquid supply device 11 of the first immersion mechanism 1 to supply a predetermined amount of the liquid LQ, and using the liquid recovery device 21 to recover a predetermined amount of the liquid LQ, and locally forms the liquid immersion region LR1 of the liquid LQ on the substrate P.

Further, the exposure apparatus EX is provided with a second immersion mechanism 2 for forming immersion regions LR2 of liquid LQ on the measurement stage ST2. The second immersion mechanism 2 is equipped with second nozzle members 72 that are provided to positions in line with the first nozzle member 70 and which have supply ports 32 for supplying the liquid LQ, and a liquid supply device 31 for supplying the liquid LQ to supply pipes 33 and the measurement stage ST2 via the supply ports 32 that are provided to the second nozzle members 72.

The example employed in this embodiment will be for the case where a scanning type exposure apparatus (a so-called scanning stepper) is used for the exposure apparatus EX. In this scanning type exposure apparatus, the image of the pattern formed on the mask M is exposed onto substrate P while simultaneously moving the mask M and the substrate P in their respective scanning directions. In the following description, the synchronous movement direction of the mask M and the substrate P in a horizontal plane is designated as the Y axis direction (the scanning direction), the direction perpendicular to the Y axis direction in a horizontal plane is designated as the X axis direction (the non-scanning direction), and the direction that is perpendicular to the X axis and the Y axis directions (the direction parallel to the optical axis AX of the projection optical system PL in this example) is designated as the Z axis direction. Furthermore, rotation (inclination) directions about the X axis, the Y axis and the Z axis, are designated as the θX, the θY, and the θZ directions respectively. The "substrate" here includes a photosensitive material (photoresist) which is spread on a base material such as a semiconductor wafer, a protective film or other such film coating, or the like. The "mask" includes a reticle formed with a device pattern which is reduced in size and projected onto the substrate.

The illumination optical system IL has a light source for exposure, an optical integrator for making the luminance distribution of the light beam emitted from the exposure light source uniform, a condenser lens for condensing the exposure light EL from the optical integrator, a relay lens system, and a field stop for setting the illumination area on the mask M that is formed by the exposure light EL, etc. A specified illumination area on the mask M is illuminated using the illumination optical system IL, with exposure light EL having a uniform luminance distribution. For the exposure light EL radiated from the illumination optical system IL, for example, emission lines (g line, h line, i line), emitted for example from a mercury lamp, deep ultraviolet beams (DUV light beams) such as the KrF excimer laser beam (wavelength: 248nm), and vacuum ultraviolet light beams (VUV light beams) such as the ArF excimer laser beam (wavelength: 193nm) and the F₂ laser beam (wavelength: 157nm), may be used. In this embodiment, the ArF excimer laser beam is used.

In this embodiment, pure water is used as the liquid LQ. Pure water can transmit not only an ArF excimer laser beam but also, for example, emission lines (g line, h line, or i line) emitted from a mercury lamp and deep ultraviolet light (DUV light) such as a KrF excimer laser beam (wavelength: 248 nm).

The mask stage MST holds the mask M and is movable. The mask stage MST holds the mask M by means of vacuum suction, for example. Using the drive from a driving device MD which includes a linear motor or the like controlled by the controller CONT, the mask stage MST, while holding the mask M, is capable of two-dimensional movement in the plane perpendicular to the optical axis AX of the projection optical system PL, i.e., the XY plane, and of fine rotation in the θZ direction. A movement mirror 51 is provided on the mask stage MST. A laser interferometer 52 is provided to a position opposite the movement mirror 51. The position in the two dimensional direction of the mask M on the mask stage MST, and the angle of rotation in the θZ direction (including the angle of rotation in the θX and θY direction in some cases) of the mask M on the mask stage MST are measured in real time by the laser interferometer 52. The results of these measurements by the laser interferometer 52 are output to the controller CONT. The controller CONT drives the driving device MD based on the results of the measurements from the interferometer 52, and carries out positional control of the mask M being held by the mask stage MST. Note that it is acceptable to provide only one part (the optical system, for example) of the laser interferometer 52 to the movement mirror 51. Further, the movement mirror 51 may include not only a plane mirror, but also a corner cube (retroreflector), and instead of securing the movement mirror 51 to the mask stage MST, a mirror surface may be used which is formed by mirror polishing, for example, the end face (side face) of the mask stage MST. Furthermore, the mask stage MST may be of a construction capable of coarse/fine movement as disclosed for example in Japanese Unexamined Patent Application, First Publication No. H08-130179 (corresponding to U.S. Patent No. 6,721,034).

The projection optical system PL is one which projects a pattern image of the mask M onto the substrate P at a predetermined projection magnification β, and has a plurality of optical elements, and these optical elements are held in a lens barrel PK. The projection optical system PL is a reduction system with a projection magnification β of, for example, 1/4, 1/5, 1/8 or the like, and forms a reduced image of the mask pattern on the aforementioned illumination region and the conjugate projection region AR. The projection optical system PL may be a reduction system, an equal system or a magnification system. Furthermore, the projection optical system PL may include any one of: a refractive system which does not include a reflection optical element, a reflection system which does not include a refractive optical element, or a cata-dioptric system which includes a reflection optical system and a refractive optical system. Furthermore, in the present embodiment, of the plurality of optical elements of the projection optical system PL, only the final optical element LS1 which is closest to the image plane of the projection optical system PL is protrudes from a lens barrel PK.

The substrate stage ST1 has a substrate holder PH for holding the substrate P, and is capable of moving while holding the substrate P in the substrate holder PH. The substrate holder PH holds the substrate P by vacuum suction, for example. The substrate holder PH for holding the substrate P is arranged in a recess portion 58 which is provided in the substrate stage ST1, and an upper surface 57 of the substrate stage ST1 other than the recess portion 58 becomes a flat surface of approximately the same height (flush) as the surface of the substrate P which is held in the substrate holder PH. This is because a part of the immersion region LR1 which runs out from the surface of the substrate P is formed on the upper surface 57, at for example the time of the exposure operation of the substrate P. Only one part of the upper surface 57 of the substrate stage ST1, for example, a predetermined region surrounding the substrate P (including the region where the immersion region LR1 runs out), may be approximately the same height as the surface of the substrate P. Furthermore, if the optical path space K1 on the image plane side of the projection optical system PL is continuously filled with the liquid LQ (for example, the immersion region LR can be favorably maintained), then there may be a step between the surface of the substrate P which is held in the substrate holder PH, and the upper surface 57 of the substrate stage ST1. Furthermore, the substrate holder PH may be formed in a unitary manner with one part of the substrate stage ST1. However, in the present embodiment, the substrate holder PH and the substrate stage ST1 are made separately, and the substrate holder PH is secured in the recess portion 58 by, for example, vacuum suction.

The substrate stage ST1, while holding the substrate P via the substrate holder PH, is two-dimensionally movable in the XY-plane on the base member BP, and is capable of fine rotation in the θZ direction, by means of drive from a substrate stage driving device SD1 including, for example, a linear motor controlled by the controller CONT. Furthermore, the substrate stage ST1 is also movable in the Z axis direction and in the θX and θY directions. Therefore, the upper surface of the substrate P held in the substrate stage ST1 is movable in a direction of six degrees of freedom of: the X axis, Y axis, Z axis, θX, θY and θZ directions. A movement mirror 53 is provided on a side surface of the substrate stage ST1. A laser interferometer 54 is provided at a position facing the movement mirror 53. The two-dimensional position and rotation angle of the substrate P on the substrate stage ST1, etc., are measured by the laser interferometer 54 in real time. Furthermore, the exposure apparatus EX includes a focus leveling detection system (not shown in the figure) that detects surface position information of the substrate P supported by the substrate stage ST1.

Note that it is acceptable to provide only a part (the optical system, for example) of the laser interferometer 54 to the movement mirror 53. The laser interferometer 54 may also be capable of measuring the position in the Z axis direction of the substrate stage ST1, and the rotation angle information in the θX and the θY directions. More detail of this is disclosed for example in Japanese Unexamined Patent Application, First Publication No. 2001-510577 (corresponding to PCT International Publication No. WO 1999/28790). Furthermore, instead of fixing the movement mirror 53 to the substrate stage ST1, a reflection surface may be used where, for example, a part of the substrate stage ST1 (the side face or the like) is formed by a mirror polishing process.

Furthermore, the focus leveling detection system is one which detects inclination information (rotation angle) for the θX and the θY directions of the substrate P by measuring position information for a plurality of measurement points for the Z axis direction of the substrate P. Regarding this plurality of measurement points, at least one part may be set within the immersion region LR1 (or the projection region AR), or all of these may be set on the outside of the immersion region LR1. Moreover, when for example the laser interferometer 54 is capable of measuring the position information for the Z axis, and the θX, and the θY directions of the substrate P, then it is possible to measure the position information for the Z axis direction during the exposure operation of the substrate P, and hence the focus leveling detection system need not be provided, and position control of the substrate P in relation to the Z axis, and the θX, and the θY directions can be performed using the measurement results of the laser interferometer 54, at least during the exposure operation.

Measurement results from the laser interferometer 54 and detection results from the focus leveling detection system are outputted to the controller CONT. The controller CONT drives the substrate stage driving device SD1 based on the detection results from the focus leveling detection system so as to control the focus position (Z position) and inclination angles (θX, θY) of the substrate P such that the upper surface of the substrate P is adjusted to match the image plane formed via the projection optical system PL and the liquid LQ, and, at the same time, controls the position of the substrate P in relation to the X axis, Y axis, and θZ directions based on the measurement results from the laser interferometer 54.

Measurement stage ST2 mounts various types of measuring devices for carrying out measurements related to exposure processing, and is provided in a manner to permit movement on the base part BP at adjacent the image plane side of the projection optical system PL. The measurement stage ST2 is driven by the measurement stage driving device SD2. The measurement stage driving device SD2 is controlled by the controller CONT. Further, the controller CONT is capable of independently moving the substrate stage ST1 and the measurement stage ST2 on the base part BP via the stage driving device SD1,SD2. The measurement stage driving device SD2 has the same configuration as the substrate stage driving device SD 1. As in the case of substrate stage ST1, the measurement stage ST2 is capable of movement in each of the X, Y, and Z axis directions, as well as in the θX, θY, and θZ directions via the measurement stage driving device SD2. The movement mirror 55 is provided to the side surface of the measurement stage ST2, and a laser interferometer 56 is provided to a position opposite the movement mirror 55. The position in two dimensions and the rotation angle of the measurement stage ST2 is measured in real time by the laser interferometer 56. The controller CONT controls the position of the measurement stage ST2 based on the measured results of the laser interferometer 56. Note that it is acceptable to provide only a part (the optical system, for example) of the laser interferometer 54 to the movement mirror 55. The laser interferometer 56 may also be capable of measuring the position in the Z axis direction of the measurement stage ST2, and the rotation information in the θX and the θY directions. Furthermore, instead of fixing the movement mirror 55 to the measurement stage ST2, a reflection surface may be used where for example a part of the measurement stage ST2 (the side face or the like) is formed by a mirror polishing process.

Examples of the measuring device that is mounted on the measurement stage ST2 include a reference mark plate on which a plurality of reference marks is formed, such as disclosed in Japanese Unexamined Patent Application, First Publication No. H05-21314 (corresponding to U.S Patent No. RE 36,730); measuring the illumination irregularity such as disclosed in Japanese Unexamined Patent Application, First Publication No. S57-117238 (corresponding to U.S. Patent No. RE 32,795); an illumination-irregularity sensor for measuring the amount of change in the rate of transmission of the exposure light EL in a projection optical system PL such as disclosed in Japanese Unexamined Patent Application, First Publication No. 2001-267239 (corresponding to U.S. Patent No. 6,721,039); a spatial image measuring sensor such as disclosed in Japanese Unexamined Patent Application, First Publication No. 2002-14005 and Japanese Unexamined Patent Application, First Publication No. 2002-198303 (corresponding to U.S. Patent Application, Publication No. 2002/0041377A1); and an irradiation quantity sensor (illuminance sensor) such as disclosed in Japanese Unexamined Patent Application, First Publication No. H11-16816 (corresponding to U.S. Patent Application, Publication No. 2002/0061469A1). In this way, the measurement stage ST2 is a stage used exclusively for carrying out measurement processing relating to exposure procedures, and has a design which does not provide for holding the substrate P, while the substrate stage ST1 has a design which does not provide for mounting measuring devices for carrying out measurements related to exposure procedures. Note that exposure apparatuses provided with this type of measurement stage are disclosed in greater detail in, for example, Japanese Unexamined Patent Application, First Publication No. H11-135400 (corresponding to PCT International Patent Publication No. WO 1999/23692) and Japanese Unexamined Patent Application, First Publication No. 2000-164504 (corresponding to U.S. Patent No. 6,897,963).

The upper surface 59 of the measurement stage ST2 is provided to a position in line with the upper surface 57 of the substrate stage ST1 which includes the surface of the substrate P. In the present embodiment, for example, by driving at least one of either the stage ST1 or stage ST2 in the Z axis direction (and/or the θX, θY direction), it is possible to control (adjust) the upper surface 57 of the substrate state ST1 and the upper surface 59 of the measurement stage ST2 to have roughly the same height position.

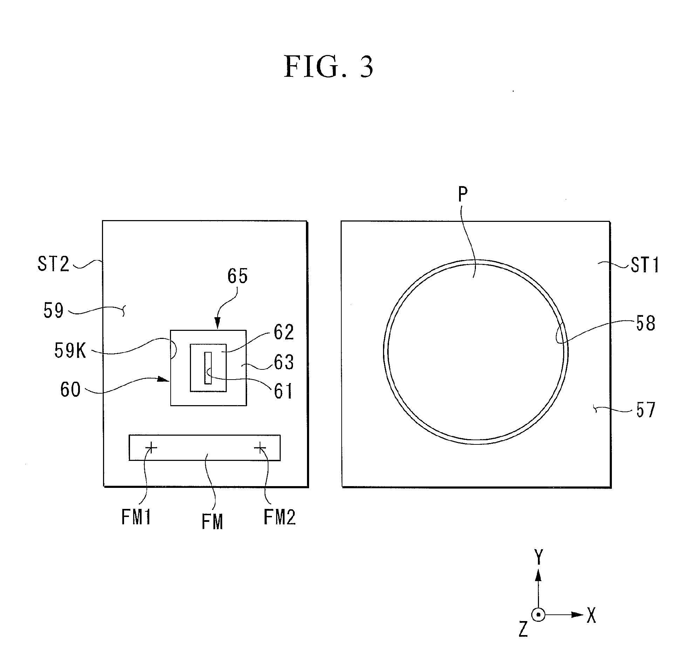

A mask alignment system RA is provided near the mask stage MST. Mask alignment system RA consists of a TTR type alignment system that employs exposure wavelength light in order to simultaneously observe the reference mark (first reference mark) FM1 on top of the reference mark plate FM (Figure 3) of the measurement stage ST2 corresponding to the alignment mark on top of mask M via the projection optical system PL. The mask alignment system according to the present embodiment employs a VRA (visual reticule alignment) method such as disclosed in Japanese Unexamined Patent Application, First Publication No. H07-176468 (corresponding to U.S. Patent No. 6,498,352), in which light (exposure light EL) is radiated onto a mark, and the image data of the mark captured by a CCD camera or the like is subjected to image processing to detect the mark position. In the present embodiment, the mask alignment system RA detects the reference mark (first reference mark) on the substrate mark plate via the projection optical system PL and the liquid LQ.

An off-axis type alignment system ALG is provided near the end of the projection optical system PL for detecting the alignment mark on the substrate P and the reference mark (second reference mark) FM2 on the reference mark plate FM which is provided to the measurement stage ST2. In the alignment system ALG according to the present embodiment, an FIA (field image alignment) method is employed such as disclosed in Japanese Unexamined Patent Application, First Publication No. H04-65603 (corresponding to U.S. Patent No. 5,995,234), in which the position of a mark is measured by irradiating a subject mark with a broad band detection light bundle which does not photosensitize the photosensitive material on the substrate P, the subject mark image developed on the light receiving surface by the reflected light from the subject mark, and the reference image (reference pattern on the reference plate provided in the alignment system), not shown in the figures, are captured using an image capturing element (CCD, etc.), and these captured image signals are then subjected to image processing. In the present embodiment, the alignment system ALG detects the reference mark (second reference mark) FM2 on the reference mark plate FM and the alignment mark on the substrate P without passing through the liquid LQ.

Next is a description of the first immersion mechanism 1. The liquid supply device 11 of the first immersion mechanism 1 is for supplying a liquid LQ for filling the optical path space K1 on the light emitting side of the final optical element LS1, and is provided with: a tank for holding liquid LQ, a pressure pump, a temperature adjusting device for adjusting the temperature of the liquid LQ being supplied, and a filter unit for removing impurities from the liquid LQ. One end of a supply pipe 13 is connected to the liquid supply device 11 and the other end of the supply pipe 13 is connected to a first nozzle member 70. Controller CONT controls the action of supplying liquid by the liquid supply device 11. Note that it is not necessary to supply all of these, i.e., the tank of the liquid supply device 11, the pressure pump, the temperature adjusting mechanism, the filter unit, etc. to the exposure light apparatus EX. Rather, it is acceptable to substitute these with equipment of the factory or the like where the exposure apparatus EX is installed.

The liquid recovery device 21 of the first immersion mechanism 1 recovers the liquid LQ which fills the optical path space K1 on the light emitting side of the final optical element LS1, and is provided with a vacuum system of a suction pump, a gas/liquid separator for separating the recovered liquid LQ and gas, and a tank for holding the recovered liquid LQ. One end of a recovery pipe 23 is connected to a liquid recovery device 21 and the other end of the recovery pipe 23 is connected to a first nozzle member 70. Controller CONT controls the action of recovering liquid by the liquid recovery device 21. Note that it is not necessary to supply all of these, i.e., the suction pump, gas/liquid separator, tank, etc. to the exposure light apparatus EX. Rather, it is acceptable to substitute these with equipment of the factory or the like where the exposure apparatus EX is installed.

Supply ports 12 for supplying the liquid LQ and collection ports 22 for recovering the liquid LQ are formed to the bottom surface of the first nozzle member 70. The bottom surface of the first nozzle member 70 is provided essentially parallel to the XY plane. When substrate stage ST1 and measurement stage ST2 are disposed opposite the projection optical system PL (final optical element LS1), that position is determined so that a specific gap is formed between the surface of the substrate P and the upper surfaces 57, 59. The first nozzle member 70 is an annular member provided so as to surround the side surface of at least the final optical element LS 1. A plurality of supply ports 12 are provided to the bottom surface of the first nozzle member 70 so as to surround the optical path space K1. Further, collection ports 22 are provided on the bottom surface of the first nozzle member 70 so as to be further to the outside than the supply ports 12 with respect to the optical path space K1, and are provided in an annular form so as to surround the optical path space K1 (final optical element LS1) and the supply ports 12. Further, there is a porous member provided to the collection ports 22 in the present embodiment. The porous member is comprised of a ceramic or titanium plate-shaped mesh, for example.

The structure of the first nozzle member 70 is not limited to that shown in FIG. 1. Namely, the bottom surface of the first nozzle member 70 is set to have roughly the same height (Z position) as the bottom end surface of the projection optical system PL of the first nozzle member 70, however, it is not limited thereto. For example, the bottom surface of the first nozzle member 70 may be set to be closer to the image plane side (substrate side) than the bottom end surface of the projection optical system PL. In this case, a part (bottom end portion) of the first nozzle member 70 is provided on the bottom side of the projection optical system PL (final optical element LS1) so as to not block the exposure light EL. Further, supply ports 12 are provided to the bottom surface of the first nozzle member 70 in this embodiment, however, the present invention is limited thereto. Rather, for example, it is also acceptable to provide supply ports 12 to the inner surface (inclined surface) of the first nozzle member 70 opposite the side surface of the final optical element LS1 of the projection optical system PL.

Controller CONT supplies a specific amount of liquid LQ from the liquid supply device 11 of the first immersion mechanism 1, and recovers a specific amount of liquid LQ using the liquid recovery device 21 of the first immersion mechanism 1. In this way, controller CONT fills the optical path space K1 with the liquid LQ and locally forms an immersion region LR1 of liquid LQ. When forming an immersion region LR1 of the liquid LQ, the controller CONT respectively activates the liquid supply device 11 and the liquid recovery device 21 of the first immersion mechanism 1. When the liquid LQ from the liquid supply device 11 is delivered under the control of controller CONT, the liquid LQ delivered from the liquid supply device 11 flows through a supply pipe 13, and then passes through the supply path formed inside the first nozzle member 70, to be supplied from the supply ports 12 to the optical path space K1 on the image plane side of the projection optical system PL. In addition, when the liquid recovery device 21 is activated under the control of the controller CONT, the liquid LQ in the optical path space K1 on the image plane side of the projection optical system PL flows via the collection ports 22 through the collection path formed inside the first nozzle member 70 and, after flowing through the recovery pipe 23, is recovered in the liquid recovery device 21.

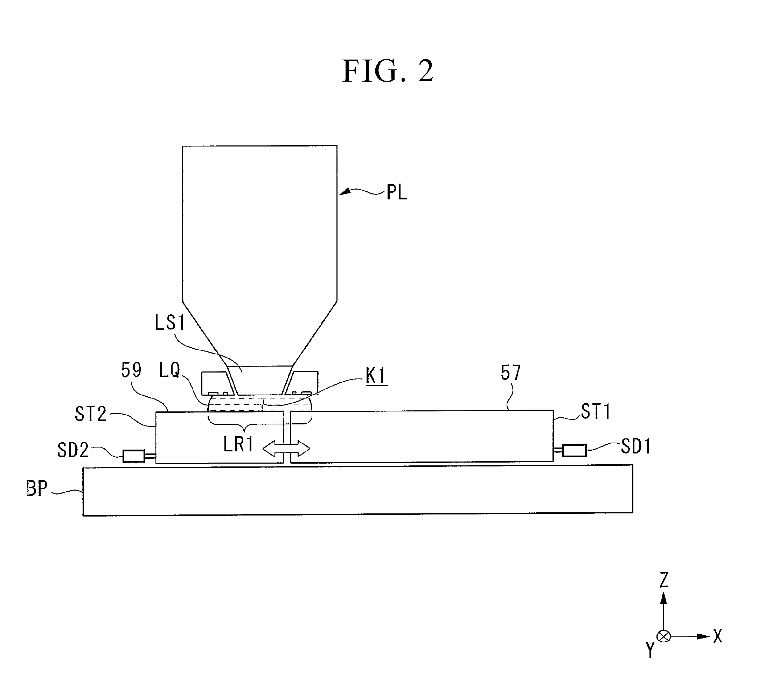

As shown in FIG. 2, the liquid immersion region LR1 that is formed in the first immersion mechanism 1 on the light emitting side of the final optical element LS of the projection optical system PL can move between the top of the substrate stage ST1 and the measurement stage ST2. When moving the liquid immersion region LR1, the controller CONT utilizes the stage driving devices SD1, SD2 to cause the substrate stage ST1 and the measurement stage ST2 to come into contact or approach one another. In this state, the substrate stage ST1 and the measurement stage ST2 move together in the same direction (the X direction, for example), and the liquid immersion region LR1 that is formed by the first immersion mechanism 1 is moved between the upper surface 57 of the substrate stage ST1 and the upper surface 59 of the measurement stage ST2 while being maintained (held) between the final optical element LS1 of the projection optical system PL (and the first nozzle member 70). In this case, the upper surfaces 57,59 of the substrate stage ST1 and the measurement stage ST2 are set to approximately the same height (Z position) and driving thereof is carried out in parallel. By providing this design, it is possible to move the liquid immersion region LR1 between the substrate stage ST1 and the measurement stage ST2 under a condition in which the outflow of liquid LQ from the gap between the substrate stage ST1 and the measurement stage ST2 is restricted, while at the same time, the optical path space K1 on the image plane side of the projection optical system PL is filled with the liquid LQ.

FIG. 3 is a planar view showing the substrate stage ST1 and the measurement stage ST2 as seen from above. In FIG. 3, the above-described reference mark plate FM is disposed on the upper surface 59 of the measurement stage ST2. The reference mark (first reference mark) FM1, which is detected with the mask alignment system RA, and the reference mark (second reference mark) FM2, which is detected with the alignment system ALG, are formed to have a specific positional relationship in the reference mark plate FM. In order to determine the alignment position of the substrate P with respect to the pattern image of the mask M after it has passed through the projection optical system PL, the reference mark plate FM is employed to measure the positional relationship (baseline value) between the position of projection of the pattern image and the detection reference of the alignment system ALG in the XY plane.
As described above, the mask alignment system RA is designed to measure the reference mark FM1 on the reference mark plate FM via the projection optical system PL and the liquid LQ. When performing measurements using the reference mark plate FM, the controller CONT carries out measurements using the reference mark plate FM in an arrangement such that the space between the final optical element LS1 and the reference mark plate FM (first reference mark FM1) is filled with liquid LQ (i.e., in a state in which at least a portion of the reference mark plate FM (at least first reference mark FM1 in this example) is disposed inside the liquid immersion region LR1 when the measurement stage ST2 and the projection optical system PL (final optical element LS1) are made to oppose one another. Accordingly, the reference mark plate FM is disposed onto the measurement stage ST2, and functions as a measuring member comprising the measuring device for carrying out measurements related to exposure processing when the space with the final optical element LS 1 is filled with liquid LQ.

An upper plate 65, which forms a portion of the spatial image measuring sensor described above, is provided to the upper surface 59 of the measurement stage ST2 as a measuring member. Note that while omitted from the figures, an upper plate which forms a portion of the illumination irregularity sensor, and an upper plate which forms a portion of the radiation sensor, etc., are also disposed to the top surface 59 of the measurement stage ST2.

The upper surface of the reference mark plate FM and the upper surface of the upper plate 65 of the spatial image measuring sensor 60 are in approximately the same plane as the upper surface 59 of the measurement stage ST2. In other words, the upper surface 59 of the measurement stage ST2 and the upper surface of each of the measuring members are provided so as to have approximately the same height as (be flush with) one another, and the upper surface 59 of the measurement stage ST2 is designed to include the upper surface of each of the measuring members. Note that it is desirable that the upper surface 59 of the measurement stage ST2 and/or the upper surfaces of each of the measuring members have a repellant property with respect to the liquid LQ.

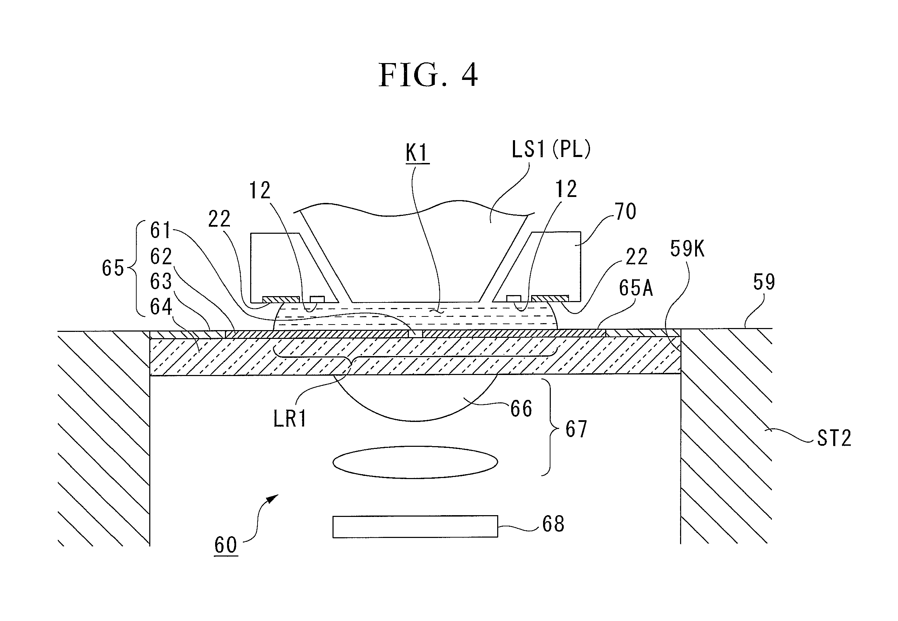

Figure 4 is a diagram showing the spatial image measuring sensor 60. This spatial image measuring sensor 60 is employed to measure the image forming characteristics (optical characteristics) of the projection optical system PL. The spatial image measuring sensor 60 is provided with an upper plate 65 which is disposed on the measurement stage ST2, a light receiving element (optical sensor) 68 consisting of a photoelectric transfer element, and an optical system 67 for guiding the light which has passed through the upper plate 65 to the light receiving element 68.

As shown in FIG. 4, an opening 59K is formed in part of the upper surface 59 of the measurement stage ST2. Upper plate 65 engages in this opening 59K. Further, an inner space which connects to this opening 59K is formed inside the measurement stage ST2, and optical system 67 which comprises the spatial image measuring sensor 60 is disposed in this inner space.

Upper plate 65 is provided with a light blocking film 62 consisting of chrome or the like that is provided in the center of the upper surface of a flat rectangularly-shaped glass plate member 64; a reflective film 63 consisting of aluminum or the like provided about the circumference of the light blocking film 62, i.e., to the area on the upper surface of glass plate member 64 where the light blocking film 62 is not disposed; and a slit 61 which is an open pattern formed in a part of the light blocking film 62. The glass plate member 64, which is a transparent element, is exposed at this slit 61, and light can pass through the slit 61. In other words, slit 61 functions as a light transmitting component formed in the upper plate 65.

The light receiving element 68 receives light (exposure light EL) that has passed through the projection optical system PL and the liquid LQ via the upper plate 65 (slit 61) and the optical system 67. The optical system 67 includes a first optical element 66 that is disposed to a position near the upper plate 65 in the inner space of the measurement stage ST2. The first optical element 66 is disposed in a unitary manner with the glass plate member 64 below the slit 61 in the inner space of the measurement stage ST2. Accordingly, even in the case where the number of openings NA in the projection optical system PL employed for immersion is greater than one, light can pass from the projection optical system PL through the liquid LQ, slit 61, and glass plate member 64, and then incident on the first optical element 66, without passing through a gaseous component.

A photoelectric transfer element, such as, for example, a photo multiplier tube (PMT) or the like capable of detecting extremely weak light with good efficiency is employed in the light receiving element 68. The photoelectric transfer signal from the light receiving element 68 is sent to the controller CONT via a signal processing device or the like.

When using the spatial image measuring sensor 60 to measure the image forming characteristics in the projection optical system PL, the measurement mask, in which the spatial image measuring pattern is formed, is held by the mask stage MST. Further, with the projection optical system PL and the measurement stage ST2 opposite one another, controller CONT uses the first immersion mechanism 1 to fill the space between the projection optical system PL and the upper plate 65 with the liquid LQ, forming an immersion region LR1 on the upper plate 65 so that slit 61 is covered over by liquid LQ. As discussed above, the immersion region LR1 can move between the substrate stage ST1 and the measurement stage ST2. Namely, with the projection optical system PL and the substrate stage ST1 positioned opposite one another, the controller CONT initiates the supply of liquid LQ using the first immersion mechanism 1, and forms an immersion region LR1 on the substrate stage ST1. Thereafter, by moving this formed immersion region LR1 onto the measurement stage ST2, an immersion region LR1 can be formed on the upper plate 65 of the measurement stage ST2. Note that when the immersion region LR1 is formed on the substrate stage ST1 prior to the aforementioned measurement, it is acceptable to move only this immersion region LR1 onto the measurement stage ST2.

The controller CONT radiates exposure light EL from the illumination optical system IL. The exposure light EL passes through the measurement mask, projection optical system PL, and the liquid LQ of the immersion region LR1, and is radiated onto the upper plate 65. The light that passes through the slit 61 of the upper plate 65 incidents on the first optical element 66 of the optical system 67. The light converged at the first optical element 66 is guided to the light receiving element 68 by the optical system 67 that is formed to include this first optical element 66. In this way, the spatial image measuring sensor 60 receives exposure light EL at the light receiving element 68 which has passed through the liquid LQ located between the final optical element LS1 and the upper plate 65, and the slit 61 formed in the upper plate 65. The light receiving element 68 outputs a photoelectric transfer signal (light quantity signal), which corresponds to the amount of light received, to the controller CONT via a signal processing device. The controller CONT carries out specific calculations based on the results received from the light receiving element 68, and determines the characteristics of the formed image that has passed through the projection optical system PL and the liquid LQ.

Note that it is acceptable not to provide the entire spatial image measuring sensor 60 to the measurement stage ST2. For example, part of the optical system 67 and/or the light receiving element 68, etc. may be disposed to a component other than the measurement stage ST2. Further, while this embodiment of the present invention employed a measurement mask during measurement of the image forming characteristics, etc. using the spatial image measuring sensor 60, the present invention is not limited thereto. For example, it is also acceptable to use the measurement pattern for mask M which is used in pattern formation, or the reference pattern formed by the mask stage MST.

Note that the above described explanation was for one example of the measurement action employing the spatial image measuring sensor 60. However, in the case where carrying out a specific measurement using the aforementioned illumination irregularity sensor, the controller CONT also employs the first immersion mechanism 1 to fill the space between the final optical element LS1 and the upper plate forming a portion of the illumination irregularity sensor that is disposed on the measurement stage ST2 with the liquid LQ, and then to receive the exposure light EL after it has passed through this liquid LQ and the light transmitting part formed on the upper plate. Similarly, in the case where carrying out a specific measurement using the aforementioned radiation sensor, the controller CONT also employs the first immersion mechanism 1 to fill the space between the final optical element LS1 and the upper plate forming a portion of the radiation sensor that is disposed on the measurement stage ST2 with the liquid LQ, and then to receive the exposure light EL after it has passed through this liquid LQ and the light transmitting part formed in the upper plate.

In this way, when the measurement stage 2 is positioned opposite the final optical element LS1, the controller CONT employs the first immersion mechanism 1 to fill the space between the final optical element LS1, and reference mark plate FM or the upper plate 65 disposed on top of the measurement stage ST2, with the liquid LQ, and, in this state, carries out measurements using the various measuring device. The results of the operations using the measuring device are then reflected in the subsequent exposure light action. In this embodiment, the measurement stage ST2 is disposed to a position opposite the final optical element LS1 as a result of its exchange with the substrate stage ST1. As a result, it is possible to continue filling the optical path space K1 on the light emitting side of the final optical element LS1 even when the substrate stage ST1 moves away from the final optical element LS1 due to substrate P exchange, etc. (i.e., it is possible to continuously maintain the liquid immersion region LR1 in between the final optical element LS1 (and the first nozzle member 70)). Further, it is similarly possible to continue filling the optical path space K1 with the liquid LQ even when disposing the substrate stage ST1 opposite the final optical element LS1 during the exchange with the measurement stage ST2.

Note that when the measurement stage ST2 is disposed opposite the final optical element LS1, it is not necessary to use all the measuring devices and measuring members loaded on measurement stage ST2. Rather, it is acceptable to carry out the appropriate measurement operations as required. For example, after exposing a given substrate P, a measurement operation employing the spatial image measuring sensor 60 may be employed, and, after exposure of the next substrate P, a measurement operation employing the reference mark plate FM may be performed.

Further, when the substrate stage ST1 is disposed to the position opposite the final optical element LS1 and the measurement stage ST2 has moved away from the final optical element LS1 (i.e., when the maintenance (holding) of the immersion region LR1 by measurement stage ST2 is released) in order to expose the substrate P, then an immersion region LR2 is formed by the second immersion mechanism 2 on the measuring member disposed on the measurement stage ST2. With the substrate stage ST1 disposed to a position opposite the final optical element LS1, the measurement stage ST2 moves to a specific position (retracted position) PJ which is removed from the projection optical system PL.

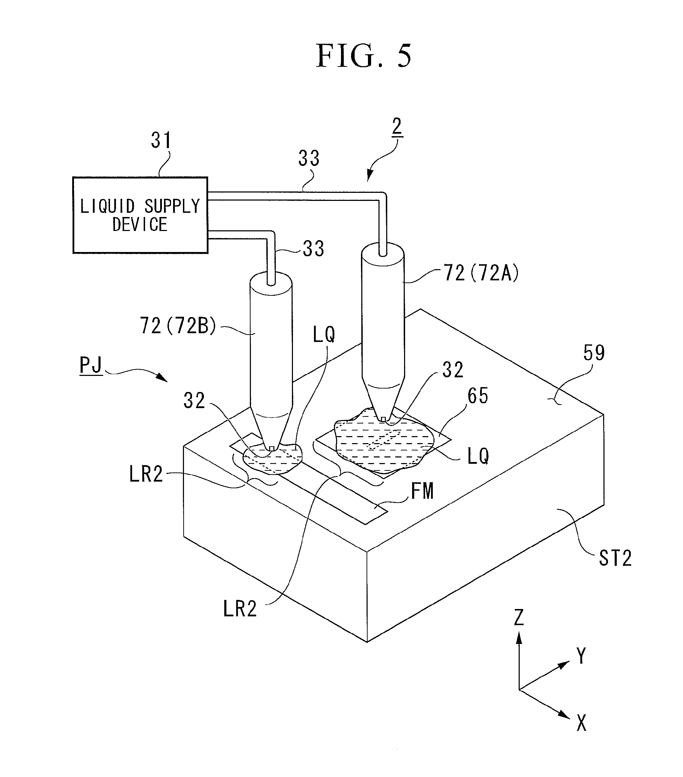

FIG. 5 is a diagram showing the second immersion mechanism 2. In FIG. 5, the second immersion mechanism 2 is provided with second nozzle members 72 that have a supply port 32 for supplying the liquid LQ; supply pipes 33 and a liquid supply device 31 for supplying the liquid (pure water) LQ, which is also employed by the first immersion mechanism 1, onto the measurement stage ST2 via the supply port 32 that is provided to the second nozzle members 72. The second immersion mechanism 2 supplies the liquid LQ to the measuring members that are disposed on top of the measurement stage ST2, and locally forms immersion regions LR2 of liquid LQ to the parts of the measurement stage ST2 that include these measuring members.

The second nozzle members 72 are provided at a specific position PJ that is separated from the first nozzle member 70 and the projection optical system PL. The supply port 32 of a second nozzle member 72 is disposed so as to be opposite the measuring member of the measurement stage ST2 when the measurement stage ST2 is moved to the specific position (retracted position) PJ separated from the projection optical system PL. In this embodiment, the second nozzle member 72 (72A, 72B) of the second immersion mechanism 2 is provided with a plurality (two) of supply ports 32 such that these are disposed opposite the upper plate 65 of the spatial image measuring sensor 60 and the reference mark plate FM (specifically, first reference mark FM1 in this example) respectively, when the measurement stage ST2 is moved to the retracted position PJ. In other words, a design is provided in which the supply port 32 of the second nozzle member 72A and the upper plate 65 are opposite one another, and the supply port 32 of the second nozzle member 72B and the reference mark plate FM are opposite one another.

The liquid supply device 31 of the second immersion mechanism 2 is for forming an immersion region LR2 of the liquid LQ to at least part of the reference mark plate FM and the upper plate 65 of the measurement stage ST2 that is disposed to the retracted position PJ. This liquid supply device 31 is provided with a tank for holding the liquid LQ, a pressure pump, a temperature adjusting device for adjusting the temperature of the liquid LQ being supplied; and a filter unit for removing foreign material from the liquid LQ. One end of the supply pipe 33 is connected to the liquid supply device 31, and the other end of the supply pipe 33 is connected to the second nozzle members 72A, 72B respectively. Further, an inner pathway (supply pathway) for connecting the supply pipe 33 and the supply port 32 is formed on the inside of the second nozzle member 72. The action of supplying the liquid from the liquid supply device 31 is controlled by the controller CONT. Note that it is not necessary that the exposure apparatus EX be equipped with the filter unit, temperature adjusting mechanism, pressure pump, tank, etc. of this liquid supply device 31. Rather, substitution with equipment of the factory or the like where the exposure apparatus EX is installed is acceptable.

With the second nozzle members 72 opposite the reference mark plate FM and the upper plate 65 on the measurement stage ST2, controller CONT supplies a specific amount of liquid LQ from the liquid supply device 31 to the supply ports 32. As a result, immersion regions LR2 can be formed to at least part of the reference mark plate FM and the upper plate 65. When the liquid LQ is delivered from the liquid supply device 31 under the control of the controller CONT, this liquid LQ delivered from the liquid supply device 31 flows through the supply pipe 33, and then passes through the supply path formed inside the second nozzle members 72, to be supplied from the supply ports 32 onto the measurement stage ST2.

The second immersion mechanism 2 supplies a specific amount of liquid LQ onto the reference mark plate FM and the upper plate 65 via the supply ports 32. As a result, immersion regions LR2 of liquid LQ are formed so as to cover at least the slit 61 of the upper plate 65 and the first reference mark FM1 of the reference mark plate FM. In this embodiment, the supply of liquid LQ is halted once the second immersion mechanism 2 has supplied a specific amount of liquid LQ from the supply ports 32. Further, this embodiment provides that the relative positional relationships between the second nozzle members 72 and the upper plate 65 and the reference mark plate FM on the measurement stage ST2 are maintained during, and for a specific amount of time after, the supply of liquid LQ from the supply ports 32. As a result, the liquid LQ can be desirably maintained between the second nozzle members 72 and the reference mark plate FM and the upper plate 65.

Next, an example of the method for exposing the substrate P using an exposure apparatus EX having the above design will be described.

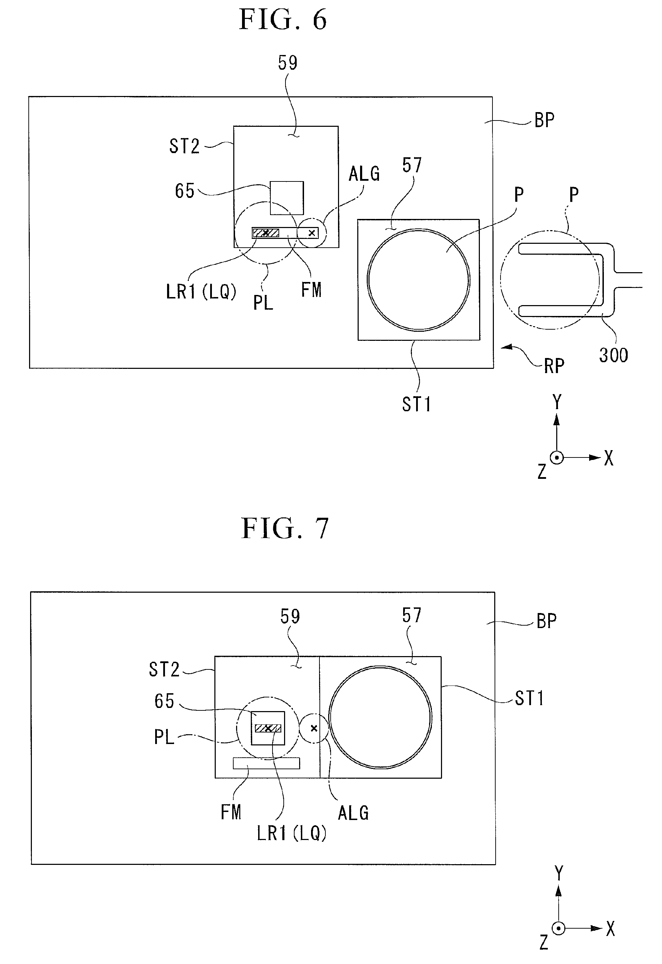

FIG. 6 is a view of the substrate stage ST1 and the measurement stage ST2 as seen from above. The controller CONT performs specific measurements using the measurement members on the measurement stage ST2 when carrying out exposure of the substrate P. One example of these measurements that may be cited is the baseline measurement of the alignment system ALG. Specifically, the controller CONT places the final optical element LS1 of the projection optical system PL and the measurement stage ST2 opposite one another, and then uses the mask alignment system RA described above to detect the first reference mark FM1 on the reference mark plate FM that is provided on top of the measurement stage ST2, and the mask alignment mark on the mask M that corresponds to this first reference mark FM1. The controller CONT then detects the positional relationship between the first reference mark FM1 and its corresponding mask alignment mark. Simultaneously, the controller CONT detects the positional relationship between the detected reference position of the alignment system ALG and the second reference mark FM2 by detecting the second reference mark FM2 on the reference mark plate FM using the alignment system ALG. As described above, in this embodiment, the controller CONT uses the first immersion mechanism 1 to fill the space between the projection optical system PL and the reference mark plate FM (first reference mark FM1) with the liquid LQ, and, in this state, carries out measurements using the mask alignment system RA. Further, based on the positional relationship between the first reference mark FM1 and its corresponding mask alignment mark, the positional relationship between the detected reference position of the alignment system ALG and the second reference mark FM2, and the positional relationship between the known first reference mark FM1 and the second reference mark FM2, the controller CONT determines the distance (positional relationship) between the center of projection of the mask pattern by the projection optical system PL and the detected reference position of the alignment system ALG, i.e., the controller CONT determines the baseline information for the alignment system ALG. FIG. 6 shows the arrangement at this point in time.

While performing the measurement operations using the measurement members on the measurement stage ST2, the controller CONT transfers the substrate stage ST1 to the substrate exchange position RP. At this substrate exchange position RP, the substrate P which is to be exposed is loaded onto the substrate stage ST1 using the conveying apparatus 300. In this way, the controller CONT disposes the measurement stage ST2 to a position opposite the final optical element LS1 so that, when the substrate stage ST1 moves away from the projection optical system PL (i.e., when the maintenance (holding) of the immersion region LR1 by substrate stage ST1 is released) due to the exchange of the substrate P, the optical path space K1 on the light emitting side of the final optical element LS 1 continues to be filled with liquid LQ. When the measurement stage ST2 is opposite the final optical element LS1, the controller CONT uses the first immersion mechanism 1 to fill the space between the final optical element LS 1 and the measuring member that is disposed on the measurement stage ST2 with the liquid LQ, and, in this state, carries out measurements using each of the various measuring devices.

Measuring operations using the measurement stage ST2 are not limited to baseline measurements. For example, measurement operations using the spatial image measuring sensor 60 may also be cited. When performing measurement operations using the spatial image measuring sensor 60, then, as shown in FIG. 7, the controller CONT disposes the immersion region LR1 formed by the first immersion mechanism 1 on top of the upper plate 65 of the measurement stage ST2. As explained with reference to FIG. 4, exposure light EL which has passed through the liquid LQ that is between the projection optical system PL and the upper plate 65, and the slit 61 that is formed in the upper plate 65, is received, and measurement of the image forming characteristics of the projection optical system PL is carried out. Similarly, measurements using the illumination irregularity sensor and/or the radiation sensor can be carried out as needed. Based on the results of these measurements, the controller CONT carries out calibration operations (adjustment of the image forming characteristics, for example) of the projection optical system PL, etc., so that these results are reflected in the exposure of subsequent substrates P.

Following completion of the loading of the substrate P onto the substrate stage ST1 and finishing measurements using the measuring members on the measurement stage ST2, controller CONT employs stage driving device SD1,SD2, and moves at least one of either the substrate stage ST1 or the measurement stage ST2. As shown in FIG. 7, after bringing the measurement stage ST2 and the substrate stage ST1 into contact with (or into the vicinity of) one another, the controller CONT moves the measurement stage ST2 and the substrate stage ST1 in the XY plane while maintaining their relative positional relationship, and carries out alignment processing on the substrate P following the exchange. Specifically, the controller CONT carries out detection of the alignment mark on the exchanged substrate P using the alignment system ALG, and determines the respective positional coordinates (array coordinates) in the plurality of shot regions disposed on the substrate P.

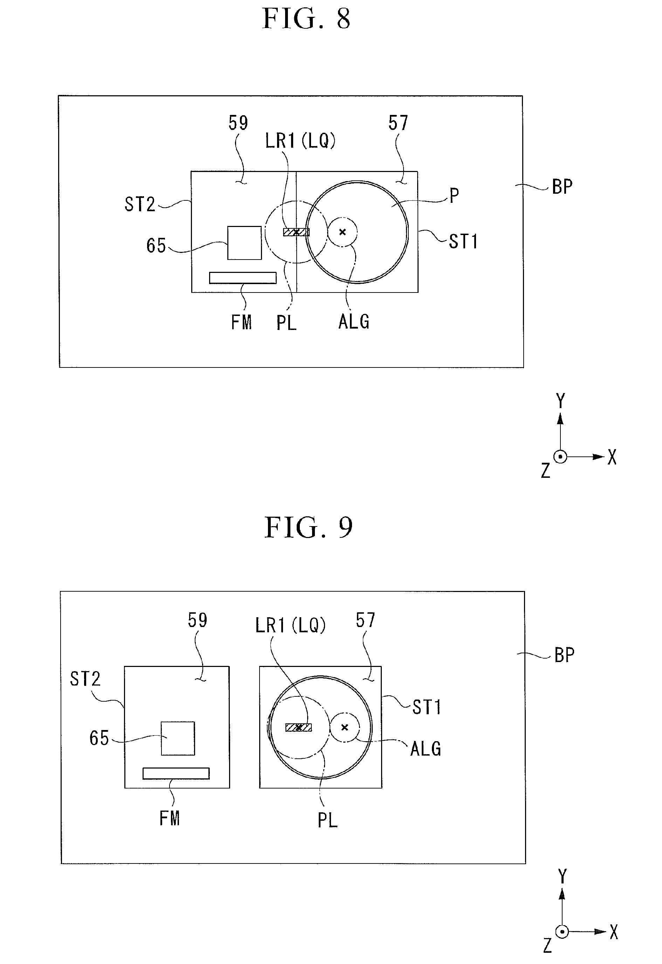

Next, while maintaining the relative positional relationships of the substrate stage ST1 and the measurement stage ST2 in the X axis direction, the controller CONT uses the stage driving device SD1, SD2, and moves the substrate stage ST1 and the measurement stage ST2 together in the -X direction. It is also acceptable to move the substrate stage ST1 and the measurement stage ST2 together in the +Y direction or the -Y direction. By moving the substrate stage ST1 and the measurement stage ST2 together, the controller CONT can move the immersion region LR1 formed between the final optical element LS1 of the projection optical system PL and the upper surface 59 of the measurement stage ST2 from the upper surface 59 of the measurement stage ST2 to the upper surface 57 of the substrate stage ST1. As shown in FIG. 8, during the movement of the immersion region LR1 of the liquid LQ that is formed by the first immersion mechanism 1 from the top surface 59 of the measurement stage ST2 to the top surface 57 of the substrate stage ST1, an immersion region LR1 is disposed extending over the upper surface 59 of the measurement stage ST2 and the upper surface 57 of the substrate stage ST1. Further, when the substrate stage ST1 and the measurement stage ST2 again move together a specific distance in the -X direction from the state shown in FIG. 8, then, as shown in FIG. 9, an arrangement is created in which the liquid LQ is held in between the final optical element LS1 of the projection optical system PL and the substrate stage ST1 (substrate P), and the immersion region LR1 of the liquid LQ formed by the first immersion mechanism 1 is disposed on the upper surface 57 of the substrate stage ST1 that includes the surface of the substrate P.

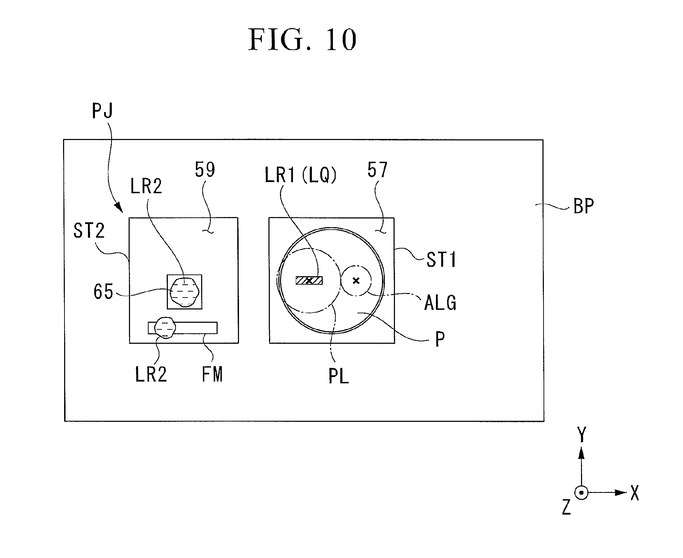

Next, the controller CONT carries out immersion exposure of the substrate P. As shown in FIG. 10, when carrying out immersion exposure of the substrate P, the controller CONT separates the substrate stage ST1 and the measurement stage ST2, and places the projection optical system PL and the substrate P on the substrate stage ST1 opposite one another. At this time, measurement stage ST2 is moved to the retracted position PJ.

Note that as long as substrate stage ST1 and measurement stage ST2 do not collide, they may be brought into contact with (or proximity to) one another once the alignment processing is completed. Alternatively, it is also acceptable to bring the substrate stage ST1 and the measurement stage ST2 into contact with (or proximity to) one another during the alignment processing. In addition, once the movement of the immersion region LR1 from the measurement stage ST2 to the substrate stage ST1 is complete, it is also acceptable during alignment processing to separate the measurement stage ST2 and the substrate stage ST1, and move the measurement stage ST2 to the retracted position PJ.

Next, the controller CONT carries out exposure of the substrate P, and sequentially transfers the mask M pattern to the respective plurality of shot regions on the substrate P. Note that positioning with respect for the mask M in each of the shot regions on the substrate P is carried out based on the positional coordinates of the multiple shot regions on the substrate P which is obtained from the results of the detection of the alignment mark on the substrate P, and on the baseline information measured immediately before.

While the substrate stage ST1 is disposed to a position opposite the final optical element LS1 of the projection optical system PL and exposure of the substrate P is being carried out, immersion regions LR2 of the liquid LQ are respectively formed by the second immersion mechanism 2 to at least part of the reference mark plate FM and the upper plate 65 of the measurement stage ST2 which is disposed to the retracted position PJ separated from the final optical element LS1 of the projection optical system PL. As was explained with reference to FIG. 5, the controller CONT supplies liquid LQ from the supply ports 32 of the second nozzle members 72 to the reference mark plate FM and the upper plate 65 of the measurement stage ST2 which has been moved to the retracted position PJ. The liquid LQ supplied from the supply port 32 spreads across the reference mark plate FM and the upper plate 65 and is held between the second nozzle member 72 and the upper surface 59 of the measurement stage ST2 that includes the upper surface of the measuring member, and an immersion region LR2 is formed to at least part of the reference mark plate FM and the upper plate 65. Since the amount of liquid LQ supplied to the reference mark plate FM and the upper plate 65 is small, the liquid LQ can be suitably held between the end of the second nozzle member 72 and the upper surface 59 of the measurement stage ST2 that includes the measuring members.

Note that in FIG. 5, the second immersion mechanism 2 forms an immersion region LR2 of the liquid LQ on part of the reference mark plate FM (including the first reference mark FM1) and on part of the upper plate 65 of the spatial image measuring sensor 60. However, it is also acceptable to form an immersion region LR2 of the liquid LQ so as to cover the entirety of the upper plate 65 and the entirety of the reference mark plate FM.

As explained with reference to FIGS. 6 and 7, when performing measurement operations using the measurement stage ST2, an immersion region LR1 is formed by the first immersion mechanism 1 to the reference mark plate FM and the upper plate 65 of the measurement stage ST2. However, once the immersion region LR1 is moved from the reference mark plate FM and the upper plate 65, if there is liquid LQ from the immersion region LR1 remaining on the upper plate 65 and the reference mark plate FM, this leads to a variety of unfavorable circumstances. For example, since solute from the resist and/or coating material on the surface of the substrate P may be included in the liquid LQ, it is possible that a water mark may form on the reference mark plate FM or the upper plate 65 if the liquid LQ remaining thereon vaporizes. Further, such undesirable conditions as thermal deformation of the reference mark plate FM or the upper plate 65 may occur due to the heat of vaporization generated from vaporization of the liquid LQ. However, when the measurement stage ST2 is separated from the final optical element LS1, it is possible to wet the upper plate 65 and the reference mark plate FM with liquid LQ that does not include impurities by using the second immersion mechanism 2 to form an immersion region LR2 on the reference mark plate FM and the upper plate 65 of the measurement stage ST2. Accordingly, it is possible to prevent such undesirable circumstances as formation of a water mark on the reference mark plate FM and the upper plate 65, thermal deformation of the upper plate 65 or reference mark plate FM, etc.

Following completion of the immersion exposure of the substrate P on the substrate stage ST1, the controller CONT employs stage driving devices SD1, SD2, and moves at least one of either the substrate stage ST1 or the measurement stage ST2 to bring the upper surface 57 of the substrate stage ST1 and the upper surface 59 of the measurement stage ST2 into contact with (or proximity to) one another. Next, opposite to what was described previously, controller CONT moves both the substrate stage ST1 and the measurement stage ST2 together in the +X direction while maintaining the relative positional relationship in the X axis direction between both stages ST1, ST2. Once the measurement stage ST2 has moved to below the projection optical system PL, the controller CONT moves the substrate stage ST1 to a specific position such as the substrate exchange position RP, etc. As a result, the immersion region LR1 formed by the first immersion mechanism 1 is disposed on the upper surface 59 of the measurement stage ST2. As explained above, the second immersion mechanism 2 supplies a specific amount of the liquid LQ from the supply port 32, after which the supply action is stopped. Accordingly, even if the measurement stage ST2 moves from below the second nozzle member 72 to below the projection optical system PL, there is no spattering or leakage of the liquid LQ from the second nozzle member 72 to the peripheral devices or members.

The liquid LQ of the immersion region LR2 formed on the measurement stage ST2 by the second immersion mechanism 2 is formed on the image plane side of the projection optical system PL by the first immersion mechanism 1, mixes with the liquid LQ that forms the immersion region LR1 that has moved from the upper surface 57 of the substrate stage ST1, and is recovered via collection ports 22 of the first nozzle member 70. Note that it is acceptable to bring the measurement stage ST2 and the substrate stage ST1 into contact with (or proximity to) one another during the exposure processing. Further, at the point when the movement of the immersion region LR1 from the substrate stage ST1 to the measurement stage ST2 is completed, the substrate stage ST1 separates from the measurement stage ST2 and moves to the substrate exchange position RP, etc.

As explained above, the measurement stage ST2 is disposed to the position opposite the final optical element LS1 even when the substrate stage ST1 separates from the projection optical system PL (final optical element LS1). As a result, it is possible to continue filling the optical path space K1 with the liquid LQ on the light emitting side of the final optical element LS 1. Accordingly, since it is possible to always keep the final optical element LS 1 wet, it is possible to avoid such undesirable circumstances as water marks forming on the final optical element LS1, thermal deformation of the final optical element LS 1 due to the heat of vaporization when the liquid LQ vaporizes, etc. In addition, using the reference mark plate FM and the upper plate 65 disposed on the measurement stage ST2, it is possible to carry out specific measurements via the liquid LQ. In addition, when the measurement stage ST2 is separated from the final optical element LS1, it is possible to use the second immersion mechanism 2 to form the immersion region LR2 on the reference mark plate FM and the upper pate 65 disposed on the measurement stage ST2. As a result, it is possible to prevent such inconvenient circumstances as water marks forming on the reference mark plate FM or upper plate 65, thermal deformation of the reference mark plate FM or the upper plate 65 due to the heat of vaporization when the liquid LQ vaporizes, etc. Accordingly, it is possible to prevent deterioration in the measurement properties of a measuring device that uses reference mark plate FM and the upper plate 65, and to desirably expose the substrate P based on the excellent measured results.

Note that in the above described embodiment, the liquid LQ supplied from the supply ports 32 of the second nozzle members 72 is recovered at the collection ports 22 of the first nozzle member 70 when the measurement stage ST2 is moved below the projection optical system PL. However, it is also acceptable to recover the liquid LQ from the reference mark plate FM and/or the upper plate 65 of the spatial image measuring sensor 60 before the measurement stage ST2 moves away from beneath the second nozzle member 72 by connecting the second nozzle member 72 to a vacuum system (exhaust system) and providing negative pressure to the flow path inside the second nozzle member 72. In this way, any liquid LQ on the reference mark plate FM and/or the upper plate 65 of the spatial image measuring sensor 60 can be prevented from moving to other parts or devices on the measurement stage ST2 as a result of movement (acceleration/deceleration) of the measurement stage ST2. Further, even in the case where liquid LQ on the reference mark FM or the upper plate 65 of the spatial image measuring sensor 60 moves a great deal on the measurement stage ST2, and the measurement stage ST2 moves below the projection optical system PL, this liquid LQ does not mix with the liquid LQ forming the immersion region LR1 that was formed by the first immersion mechanism 1. Thus, it is possible to prevent formation of water marks and/or vaporization upon drying.

### <Second Embodiment>

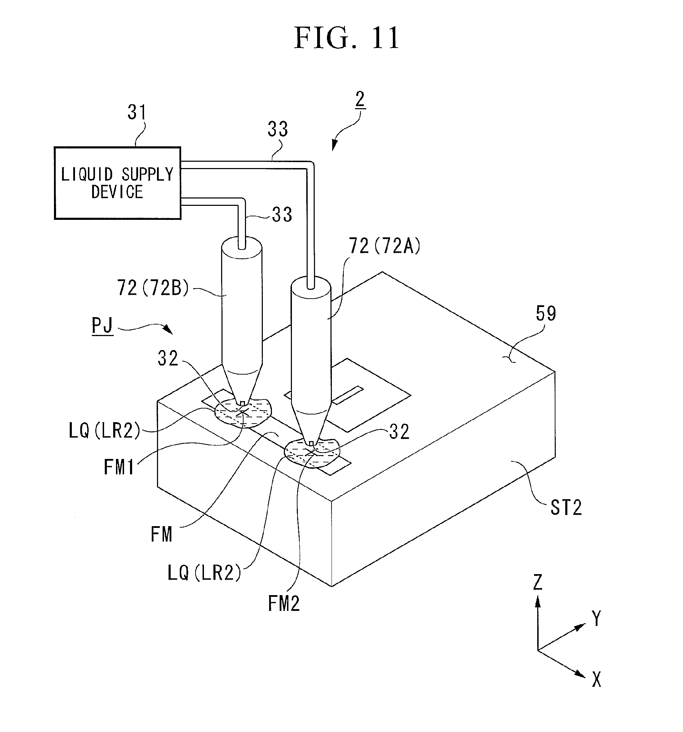

Next, a second embodiment of the present invention will be explained with reference to FIG. 11. In the following explanation, compositional parts that are the same or equivalent have been assigned the same numeric symbol as in the above described embodiment, and an explanation thereof has been simplified or omitted.

As shown in FIG. 11, the reference mark plate FM has a plurality of reference marks MF1, FM2 for the measuring patterns. In this embodiment, the second immersion mechanism 2 has a plurality of supply ports 32 that corresponds to the plurality of reference marks FM1, FM2 when the measurement stage ST2 is moved to the retracted position PJ. In this embodiment, a plurality of second nozzles 72 (72A,72B) are provided corresponding to the reference marks FM1,FM2, and each of these second nozzle members 72A,72B are provided with respective supply ports 32. The supply port 32 of the second nozzle member 72A and the second reference mark FM2 are provided opposite one another, and the supply port 32 of the second nozzle member 72B and the first reference mark FM1 are provided opposite one another. The second immersion mechanism 2 forms an immersion region LR2 so as to cover the second reference mark FM2 using the liquid LQ supplied from the supply port 32 of the second nozzle member 72A, and also forms an immersion region LR2 so as to cover the first reference mark FM1 using liquid LQ supplied from the supply port 32 of the second nozzle member 72B. In this way, it is possible to provide supply ports 32 for forming immersion regions LR2 that correspond to a variety of measurement patterns provided on the measuring members.

Note that in the first embodiment, the second reference mark FM2 was detected by the alignment system ALG during baseline measurement of the alignment system ALG Accordingly, formation of an immersion region LR2 on the second reference mark FM2 by the second immersion mechanism 2 was not carried out. However, in this embodiment, there are, for example, a plurality (two) of mask alignment systems RA provided, and different reference marks (FM1, FM2) on the reference mark plate FM are detected via respective liquid LQ in the plurality of mask alignment systems RA during baseline measurements. Accordingly, formation of an immersion region LR2 on the second reference mark FM2 is carried out. Although not shown in the figures, a reference mark that can be detected by the alignment system ALG is provided to the reference mark plate FM.

For example, when a plurality of slits (light transmitting pattern) 61 are provided as the measurement pattern to the upper plate 65 of the spatial image measuring sensor 60, a plurality of supply ports 32 can be provided so as to correspond to these various light transmitting patterns.

Note that in this second embodiment as well, it is also acceptable to recover the liquid LQ from the reference mark plate FM and/or the upper plate 65 of the spatial image measuring sensor 60 before the measurement stage ST2 moves away from beneath the second nozzle member 72, by connecting the second nozzle member 72 to a vacuum system (exhaust system). Note that in both the first and second embodiments, the positional relationship between the aforementioned specific position PJ and the projection optical system PL (projection region AR) is set so that the measurement stage ST2 and the substrate stage ST1 which is holding the substrate P do not come into contact with one another during exposure of the substrate P.

In the first and second embodiments, the second nozzle member 72 is fixed at the retracted position PJ. However, it is also acceptable to provide the second nozzle member 72 with the ability to move by attaching a driving mechanism thereto. Further, when the measurement stage ST2 is disposed to a specific position separated from the projection optical system PL, it is acceptable for controller CONT to oppose the measuring members of the measurement stage ST2 and the supply port 32 of the second nozzle member 72 opposite one another by moving the second nozzle member 72.

In the first and second embodiments, the relative positional relationship between the second nozzle member 72 and the measurement stage ST2 (measuring members) is maintained when the immersion region LR2 of the liquid LQ is formed on the measuring members that are provided to the measurement stage ST2 using the second immersion mechanism 2. However, it is also acceptable to form the immersion region LR2 while moving at least one of the second nozzle member 72 and the measurement stage ST2 (measuring members).

In the first and second embodiments, the second immersion mechanism 2 forms an immersion region LR2 on the measuring members by holding the liquid LQ between the front end of the second nozzle member 72 and the measuring members. However, it is also acceptable, for example, to drip a specific amount of the liquid LQ onto the measuring members using the supply port 32 of the second nozzle member 72, and then separate the second nozzle member 72 and the measurement stage ST2 by moving at least one of either of these. Since liquid drops of the liquid LQ dripped onto the measuring member wet and spread over the measuring members, it is possible to maintain an immersion region LR2 of the liquid LQ so as to cover at least a part of the measuring members. In this case, in the first and second embodiments, the retracted position of the measurement stage ST2 and the position of formation of the immersion region LR2 by the second immersion mechanism 2 were designed to be at the same location (i.e., the specific position PJ). However, it is also acceptable that these two positions differ. In addition, when there are a plurality of measuring members where immersion regions LR are to be formed on the measurement stage ST2, it is also acceptable to sequentially form immersion regions LR2 on a plurality of measuring members while moving at least one of either the second nozzle member 72 and the measurement stage ST2. In addition, there is no need for the number of second nozzles 72 (supply ports 32) to be the same as the number of measuring members where an immersion region LR is to be formed. For example, the number of second nozzles 72 may be less than the number of measuring members, or may be just one.

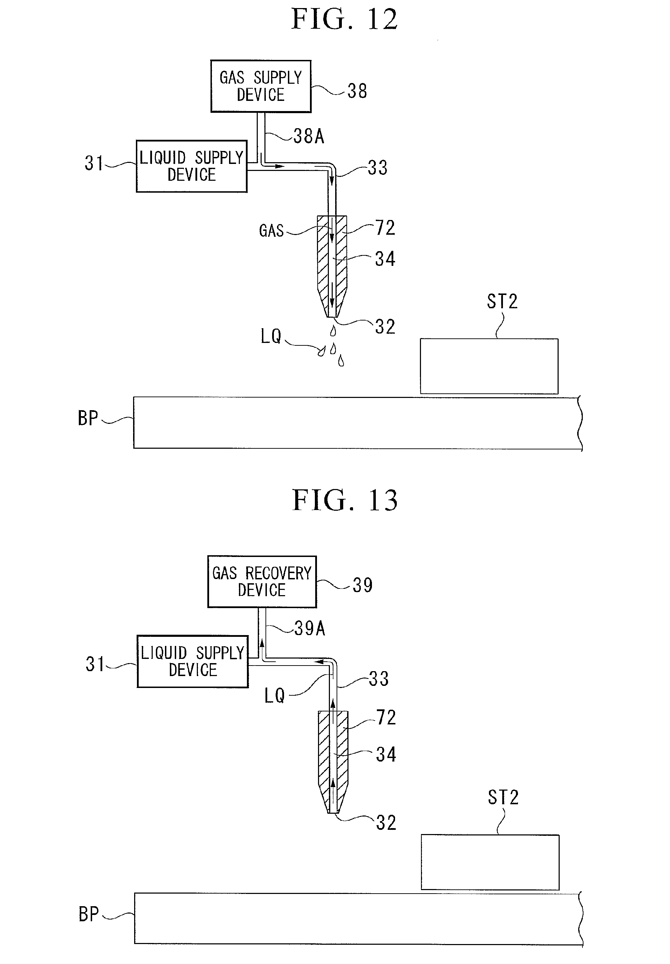

In the first and second embodiments above, the second immersion mechanism 2 supplies a fixed amount of the liquid LQ from the supply port 32 onto the measuring members, after which the supply of liquid LQ is halted. For this reason, a condition can arise in which the liquid LQ remains inside the supply pipe 33 and/or the supply flow path provided inside the second nozzle member 72 once the supply of the liquid LQ is halted, i.e., once the delivery of liquid LQ from the liquid supply device 31 to the supply port 32 is halted. When this condition of liquid LQ remaining in the supply pipe 33 and/or the supply flow path of the second nozzle member 72 persists for a long period of time, this liquid LQ can become dirty. Accordingly, an undesirable situation can arise in which the measuring members become dirty when this dirty liquid LQ is supplied onto them. In addition, as explained above, when the liquid LQ on the reference mark plate FM and/or is the upper plate 65 of the spatial image measuring sensor 60 recovered prior to moving the measurement stage ST2 from directly below the second nozzle member 72, the dirty liquid LQ can remain inside the second nozzle member 72. Accordingly, it is acceptable to expel (discharge) the dirty liquid LQ inside the second nozzle member 72 by applying a positive pressure to the flow path inside the second nozzle member 72 after the measurement stage ST2 has moved from beneath the second nozzle member 72. For example, as shown in FIG. 12, a gas supply device 38 is attached via a pipe (flow path) 38A to one part of the supply pipe 33, and gas is supplied to the supply pipe 33 from this gas supply device 38. In this way, any liquid LQ remaining in supply pipe 33 and/or the supply flow path 34 formed inside the second nozzle member 72 can be evacuated to the outside. When the substrate stage ST1 is disposed to a position opposite the projection optical system PL, then an immersion region LR2 is formed on the measuring member under an arrangement in which the second nozzle member 72 and the measurement stage ST2 are opposite one another. However, when the substrate stage ST1 moves away from the projection optical system PL as the result of substrate P exchange for example, and the measurement stage ST2 has moved to a position opposite the projection optical system PL, i.e., when the measurement stage ST2 has moved away from the supply port 32 (when the measurement stage ST2 is not at a position opposite the second nozzle member 72), the controller CONT can supply gas to the supply pipe 33 from the gas supply device 38. By supplying gas from the gas supply device 38, any liquid LQ remaining in the supply pipe 33 and/or supply flow path 34 can be expelled to the outside from supply port 32. In the present embodiment, the liquid LQ is expelled (discharged) onto the base member BP. Since the amount of liquid LQ expelled from the supply port 32 is small, there is little effect on the base member BP and the peripheral equipment/members. By supplying gas to the supply pipe 33 and the supply flow path 34 in this way, it is possible to prevent liquid LQ from remaining for a long period of time in the supply pipe 33 and/or supply flow path 34.

As shown in FIG. 13, in order to expel the liquid LQ remaining in the supply pipe 33 and/or the second nozzle member 72, one part of the supply pipe 33 is connected to a liquid recovery device 39 via a pipe (flow path) 39A. This liquid recovery device 39 is designed to include a vacuum system such as a suction pump or the like. The liquid LQ remaining in the supply pipe 33 and/or the supply flow path 34 that is formed inside the second nozzle member 72 can be suctioned and recovered through the suction action of the liquid recovery device 39. In this way, by connecting the liquid recovery device 39 that includes a vacuum system to the supply pipe 33 and the supply flow path 34, it is possible to prevent the liquid LQ from remaining in the supply pipe 33 and/or supply flow path 34 for a long period of time.

As in the case for the first nozzle member 70, collection ports may be provided to the second nozzle member 72 in the first and second embodiments. Further, as in the case of the first nozzle member 70, an immersion region LR2 of liquid LQ can be formed on the measuring member by carrying out in parallel the operation of supplying the liquid LQ onto the measuring member through the supply port 32 that is provided to the second nozzle member 72, and the operation of recovering the liquid LQ from the measuring members through collection ports that are provided to the second nozzle member 72. Further, when the second nozzle member 72 and the measurement stage ST2 separate, the supply of the liquid LQ from the supply port 32 is halted, and the liquid LQ on the measuring member can be recovered through the collection ports provided to the second nozzle member 72.

Note that in the first and second embodiments, an immersion region LR2 of liquid LQ was formed to at least part of the reference mark plate FM and at least a part of the upper plate 65 of the spatial image measuring sensor 60 using the second immersion mechanism 2. However, it is also acceptable to form the immersion region LR2 to the light transmitting area of the illumination irregularity sensor and/or the light transmitting area of the radiation sensor after the measurement stage ST2 has moved to the retracted position PJ. In other words, it is possible to determine the number and disposition of the second nozzle members 72 of the second immersion mechanism 2 so as to correspond to the members whose measurement accuracy would be affected by water marks and the like.

In the first and second embodiments, an immersion region LR2 does not need to be formed to the measuring member that is not in use while the measurement stage ST2 is disposed opposite the projection optical system PL (i.e., while the immersion region LR1 is formed on the measurement stage ST2 by the first immersion mechanism 1) and which does not come into contact with the liquid LQ of the immersion region LR1. To restate, regardless of whether it is being used or not, it is acceptable to form an immersion region LR2 only to the measuring member that is in contact (wet) with the liquid LQ of the immersion region LR1.

### <Embodiment 3>

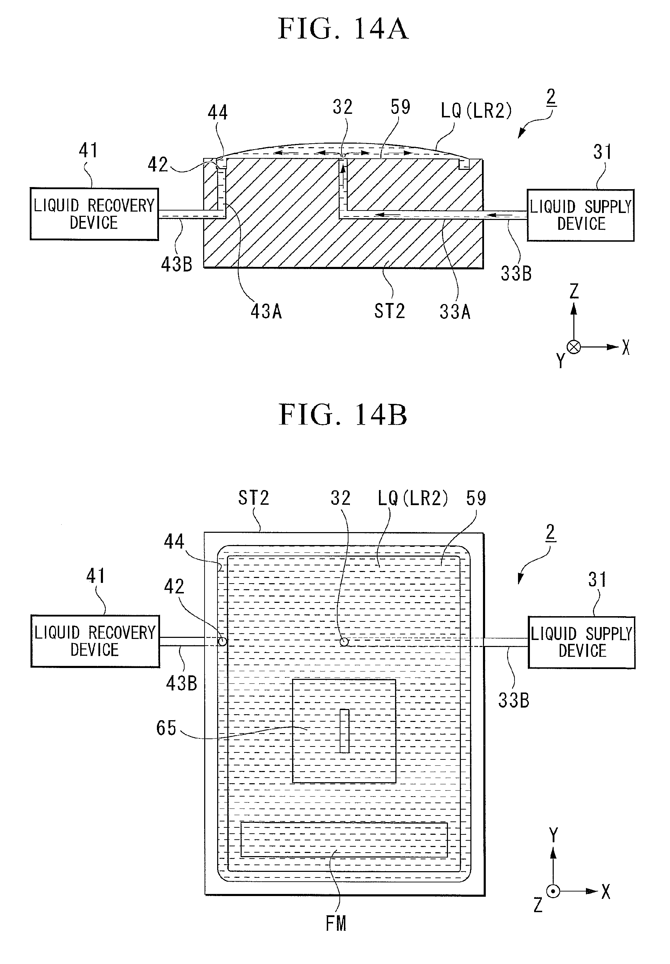

Next, a third embodiment of the present invention will be explained with reference to FIGS. 14A,14B. FIG. 14A is a lateral view in cross-section of the measurement stage ST2 according to the present invention. FIG. 14B is a planar view as seen from above. Note that in order to simplify the explanation, the illumination irregularity sensor and the radiation sensor have been omitted from the figures in this embodiment. In addition, since the structure of the second immersion mechanism 2 differs from the above-described first and second embodiments, only the second immersion mechanism 2 will be explained below, and compositional parts that are the same or similar to the first and second embodiments will be assigned the same numeric symbol and an explanation thereof will be omitted.

In FIG. 14A, 14B, the second immersion mechanism 2 has a supply port 32 on the upper surface 59 of the measurement stage ST2 for supplying liquid LQ to the upper surface 59. Supply port 32 is connected to a liquid supply device 31 via a pipe 33B and an inner flow path 33A that is formed inside the measurement stage ST2. At least a portion of the pipe 33B is formed of a member having pliability (i.e., a flexible tube) that is composed of rubber, plastic, or a bellows-shaped hose. As a result, smooth movement of the measurement stage ST2 on the base member BP is not hindered.

The supply port 32 is provided to the upper surface 59 of the measurement stage ST2 at a position other than that of the upper plate 65 and reference mark plate FM. In this embodiment, one supply port 32 is provided to a specific position on the upper surface 59 of the measurement stage ST2. Note that the number and/or position of formation of supply ports 32 can be suitably changed.

The second immersion mechanism 2 has a liquid collection groove 44 (recess portion) that is disposed to the upper surface 59 of the measurement stage ST2 so as to surround the upper plate 65, the reference mark plate FM and the supply port 32. A liquid collection port 42 that is connected to the liquid recovery device 41 is provided on the inside of the collection groove 44. The liquid recovery device 41 of the second immersion mechanism 2 is provided with a vacuum system such as a suction pump, a gas/liquid separator for separating the recovered gas and liquid LQ, and a tank for holding the recovered liquid LQ. The controller CONT controls the operation of collecting liquid by the liquid recovery device 41. Note that it is not necessary to supply all of these, i.e., the vacuum system of the liquid recovery device 41, the gas/liquid separator, the tank, etc. to the exposure light apparatus EX. Rather, substitution by equipment of the factory or the like where the exposure apparatus EX is installed is acceptable.

The collection port 42 is connected to the liquid recovery device 41 via a pipe 43B and an inner flow path 43A that is formed inside the measurement stage ST2. As in the case of the pipe member 33B, at least a portion of the pipe 43B is formed of a member having pliability (flexible tube).

In the present embodiment, one collection port 42 is provided to a specific position inside the collection groove 44. Note that the number and/or position of formation of the collection port 42 can be suitably changed.

The controller CONT supplies liquid LQ from the supply port 32 in order to form an immersion region LR2 of liquid LQ at a specific region on the measurement stage ST2 that includes the upper plate 65 and the reference mark FM. By supplying a specific amount of liquid LQ from the liquid supply device 31 of the second immersion mechanism 2 and, at the same time, recovering a specific amount of liquid LQ using the liquid recovery device 41 of the second immersion mechanism 2, controller CONT is able to form a film of the liquid LQ so as to cover the upper plate 65 and the reference mark plate FM, and to form a immersion region LR2 of the liquid LQ inside the collection groove 44. When forming the immersion region LR2 of the liquid LQ, the controller CONT drives the liquid recovery device 41 and the liquid supply device 31 of the second immersion mechanism 2. When the liquid LQ is delivered from the liquid supply device 31 under the control of the controller CONT, the liquid LQ delivered from the liquid supply device 31, after flowing through the pipe 33B and the inner flow path 33A, is supplied to the upper surface 59 of the measurement stage ST2 via supply ports 32 provided in the upper surface 59 of the measurement stage ST2. The liquid LQ supplied from the supply port 32 wets and spreads over the upper surface 59 of the measurement stage ST2, and forms an immersion region LR2 of liquid LQ so as to cover the upper plate 65 and the reference mark plate FM.

The liquid LQ of the immersion region LR2 that is formed on the upper surface 59 flows into the collection groove 44. The liquid LQ which has flowed into the collection groove 44 then flows into the inner flow path 43A via the collection port 42. After flowing into the pipe 43B, this liquid LQ is then recovered by the liquid recovery device 41. In this way, in this embodiment, of the area of the upper surface 59 of the measurement stage ST2 that includes the upper plate 65 and the reference mark plate FM, the inside of the collection groove 44 is covered with a film of liquid LQ, and an immersion region LR2 of the liquid LQ is formed on the inside of the collection groove 44.

The controller CONT forms an immersion region LR2 to the upper surface 59 on measurement stage ST2 that includes the upper plate 65 and the reference mark plate FM when the substrate stage ST1 is disposed to a position opposite the projection optical system PL and the measurement stage ST2 is separated from the projection optical system PL (i.e., when support (holding) of the immersion region LR1 by the measurement stage ST2 has been released). Even when carrying out measuring operations using the upper plate 65 and the reference mark plate FM in the arrangement when the measurement stage ST2 and the projection optical system PL are opposite one another, the controller CONT is able to form an immersion region LR2 on the measurement stage ST2 using the second immersion mechanism 2.

Note that in this embodiment, the second immersion mechanism 2 is designed to form an immersion region LR2 to almost the entire upper surface 59 of the measurement stage ST2. However, it is also acceptable to dispose the supply port and the collection groove so that the immersion region LR2 is formed to only a portion of the upper surface 59 of the measurement stage ST2. For example, a collection groove may be provided so as to surround at least a portion of the upper plate 65 of the spatial image measuring sensor 60 and/or the reference mark plate FM, and to provide the supply port to the inside thereof.

In this embodiment as well, when the measurement stage ST2 is moved to a position opposite the final optical element LS1 of the projection optical system PL, and the substrate stage ST1 and the measurement stage ST2 have been brought into contact with (or proximity to) one another, then the immersion region LR1 formed by the first immersion mechanism 1 can be moved from the substrate stage ST1 to the measurement stage ST2. The liquid LQ supplied to the measurement stage ST2 by the second immersion mechanism 2 mixes with the liquid LQ that forms the immersion region LR1 formed by the first immersion mechanism 1, and is recovered from the collection ports 22 of the first nozzle member 70.

### <Embodiment 4>

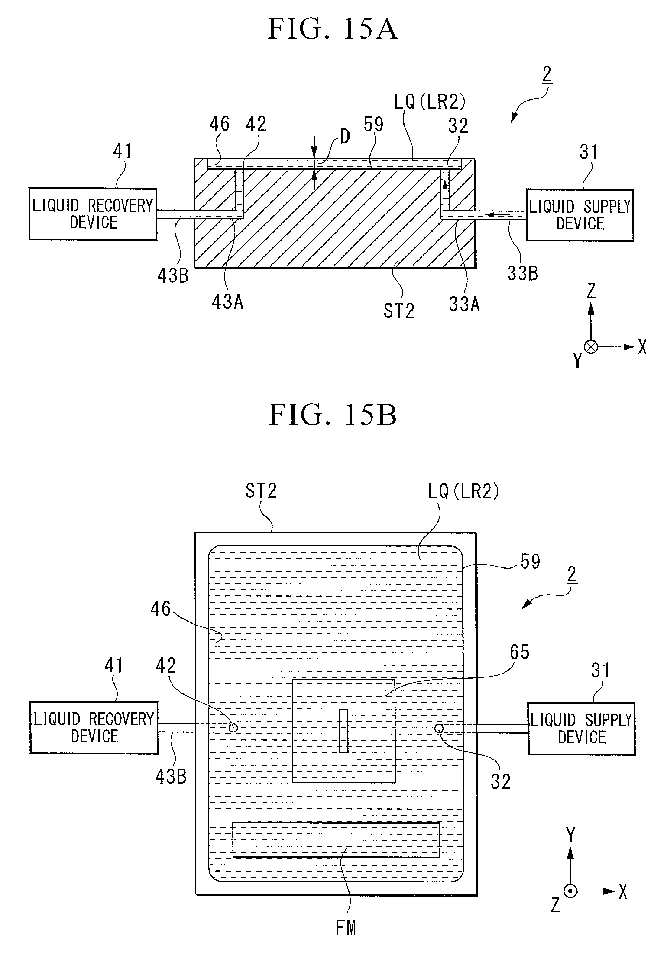

Next, a fourth embodiment of the present invention will be explained with reference to FIGS. 15A, 15B. FIG. 15A is a lateral view in cross-section of the measurement stage ST2 according to the present embodiment. FIG. 15B is a planar view of the same as seen from above. Note that in order to simplify the explanation, illumination irregularity sensor and the radiation sensor have been omitted from the figures in this embodiment. In addition, since the structure of the second immersion mechanism 2 differs from the above-described first and second embodiments, only the second immersion mechanism 2 will be explained below, and compositional parts that are the same or similar to the first and second embodiments will be assigned the same numeric symbol and an explanation thereof will be omitted.

In FIG. 15A, 15B, the second immersion mechanism 2 has a recess portion 46 in the upper plate 59 of the measurement stage ST2 that has a specific depth D that is capable of holding a specific amount of liquid LQ. Further, the upper plate 65 and the reference mark plate FM are disposed on the inside of the recess portion 46. The depth D of the recess portion 46 is set to be 1 mm or less. In this embodiment, the depth D of the recess portion 46 is set to be about 10 µm.

Further, on the upper surface 59 of the measurement stage ST2, a supply port 32, which is for providing liquid LQ to the upper surface 59, is provided to the inside of the recess portion 46. The supply port 32 is connected to the liquid supply device 31 via a pipe 33B and an inner flow path 33A that is formed inside the measurement stage ST2. The supply port 32 is provided to a position on the upper surface 59 of the measurement stage ST2 other than the position of the upper plate 65 and the reference mark plate FM. In this embodiment, one supply port 32 is provided to a specific position on the upper surface 59 of the measurement stage ST2. Note that the number and/or position of formation of supply ports 32 can be suitably changed.

A collection port 42 for recovering liquid LQ from the upper surface 59 is disposed to the upper surface 59 of the measurement stage ST2 on the inside of the recess portion 46. The collection port 42 is connected to the liquid recovery device 41 via a pipe 43B and an inner flow path 43A that is formed inside the measurement stage ST2. The collection port 42 is provided to a position on the upper surface 59 of the measurement stage ST2 other than the location of the upper plate 65 and the reference mark plate FM. In this embodiment, one collection port 42 is provided to a specific position on the upper surface 59 of the measurement stage ST2. Note that the number and/or position of formation of the collection port 42 can be suitably changed.

Controller CONT supplies liquid LQ from the supply port 32 in order to form an immersion region LR2 by filling the inside of the recess portion 46 on a measurement stage ST2 that includes upper plate 65 and reference mark FM with the liquid LQ. By supplying a specific amount of liquid LQ from the liquid supply device 31 of the second immersion mechanism 2 and, at the same time, recovering a specific amount of liquid LQ using the liquid recovery device 41 of the second immersion mechanism 2, controller CONT fills the inside of the recess portion 46 with the liquid LQ, and is able to form an immersion region LR2 of the liquid LQ so as to cover the upper plate 65 and the reference mark plate FM. When the liquid LQ is delivered from the liquid supply device 31 under the control of the controller CONT, the liquid LQ delivered from the liquid supply device 31, after flowing through the pipe 33B and the inner flow path 33A, is supplied to the upper surface 59 of the measurement stage ST2 via supply ports 32 provided in the upper surface 59 of the measurement stage ST2. The liquid LQ supplied from the supply port 32 wets and spreads over the upper surface 59 of the measurement stage ST2, and forms an immersion region LR2 of liquid LQ so as to cover the upper plate 65 and the reference mark plate FM. The liquid LQ of the immersion region LR2 that is formed on the upper surface 59 flows into the inner flow path 43A via a collection port 42. Liquid LQ then flows through the pipe 43B and is recovered by the liquid recovery device 41.

The controller CONT fills the inside of the recess portion 46 with the liquid LQ and forms an immersion region LR2 so as to cover the upper plate 65 and the reference mark plate FM when the substrate stage ST1 is disposed to a position opposite the projection optical system PL and the measurement stage ST2 is separated from the projection optical system PL (i.e., when support (holding) of the immersion region LR1 by the measurement stage ST2 has been released). Even when carrying out the measuring operation using the upper plate 65 and the reference mark plate FM in the arrangement in which the measurement stage ST2 and the projection optical system PL are opposite one another, the controller CONT is able to form an immersion region LR2 on the measurement stage ST2 using the second immersion mechanism 2 to fill the inside of the recess portion 46 with the liquid LQ.

In this embodiment as well, when the measurement stage ST2 is moved to a position opposite the final optical element LS1 of the projection optical system PL, and the substrate stage ST1 and the measurement stage ST2 have been brought into contact with (or proximity to) one another, then the immersion region LR1 formed by the first immersion mechanism 1 can be moved from the substrate stage ST1 to the measurement stage ST2. The liquid LQ supplied to the measurement stage ST2 by the second immersion mechanism 2 mixes with the liquid LQ that forms the immersion region LR1 formed by the first immersion mechanism 1, and is recovered from the collection ports 22 of the first nozzle member 70.

In the fourth embodiment, the supply port 32 is disposed to the inside of a recess portion 46, and the action of supplying the liquid via this supply port 32 and the action of recovering the liquid via the collection port 42 are carried out in parallel. However, the supply port 32 and/or the collection port 42 may omitted. In other words, it is possible to prevent such undesirable circumstances as the formation of water marks on the measuring members or thermal deformation of the measuring members caused by the heat of vaporization when the liquid LQ is vaporized by holding a portion of the liquid LQ supplied from the first nozzle member 70 inside the recess portion 46 when the projection optical system PL and the measurement stage ST2 are opposite one another.

Note that in the third and fourth embodiments, a supply port 32 is provided for supplying the liquid LQ to the upper surface 59 of the measurement stage ST2. However, it is acceptable not to provide a supply port 32 to the upper surface 59 of the measurement stage ST2, but rather to supply the liquid LQ to the upper surface 59 of the measurement stage ST2 from the supply port 32 of the second nozzle member 72 which is opposite the upper surface 59 of the measurement stage ST2, as the first and second embodiments.

In addition, in the first to fourth embodiments, it is also acceptable to separately provide a focus leveling detection system for detecting a position on the upper surface of the measurement stage ST2 (on, for example, the upper plate 65 of the spatial image measuring sensor 60) when carrying out measurements using the measuring members (measuring device) that is loaded on the measurement stage ST2 with the projection optical system PL and the measurement stage ST2 opposite one another. In this case, the position on the upper surface of the measurement stage ST2 may be optically detected via the liquid LQ that forms the immersion region LR1 formed by the first immersion mechanism 1.

Further, the measuring members (measuring devices) mounted on the measurement stage ST2 are not limited to those described in the first through fourth embodiments. Rather, the number and type thereof is optional, and various types of measuring members (measuring devices) may be mounted as necessary. For example, a wave aberration measuring device such as disclosed in PCT International Patent Publication No. WO 1999/60361 (corresponding to U.S. Patent No. 6,819,414), Japanese Unexamined Patent Application, First Publication No. 2002-71514, and U.S. Patent No. 6,650399, or the reflector disclosed in Japanese Unexamined Patent Application, First Publication No. S62-183522 (corresponding to U.S. Patent No. 4,780,747). It is also acceptable to mount a measuring member (measuring device) to the substrate stage ST1. In this case, as in the case of the above embodiments, it is acceptable to form an immersion region LR2 to the measuring member that is in contact with and wet from the liquid LQ of the immersion region LR1 on the substrate stage ST1. It is also acceptable to from two second immersion mechanisms 2 corresponding to the substrate stage ST1 and measurement stage ST2 respectively.

Note that in the first through fourth embodiments, when the measurement stage ST2 is disposed opposite the projection optical system PL (i.e., when an immersion region LR1 is formed to the measurement stage ST2 by the first immersion mechanism 1), specific measurements are carried out using the measuring members on the measurement stage ST2. However, it is not absolutely essential that specific measurements be carried out, rather, it is acceptable to carry out only maintenance (holding) of the immersion region LR1 (by the measurement stage ST2. In this case, it is acceptable to form the immersion region LR2 to only the measurement members that is wet from contact with liquid LQ of immersion region LR1 on the measurement stage ST2.

In the above embodiments, pure water (extra pure water) is used as the liquid LQ. Pure water has advantages in that it can be easily obtained in large quantity at semiconductor manufacturing plants, etc. and in that it has no adverse effects on the photoresist on the substrate P or on the optical elements (lenses), etc. In addition, pure water has no adverse effects on the environment and contains very few impurities, so one can also expect an action whereby the surface of the substrate P and the surface of the optical element provided on the front end surface of the projection optical system PL are cleaned. Further, when the purity of pure water supplied in a factory, etc. is low, the exposure apparatus can have a device for producing ultra pure water.

In addition, the index of refraction n of pure water (water) with respect to exposure light EL with a wavelength of 193 nm is nearly 1.44, so in the case where ArF excimer laser light (193 nm wavelength) is used as the light source of the exposure light EL, it is possible to shorten the wavelength to 1/n, that is, approximately 134 nm on the substrate P, to obtain high resolution. Also, the depth of focus is expanded by approximately n times, that is approximately 1.44 times, compared with it being in air, so in the case where it would be permissible to ensure the same level of depth of focus as the case in which it is used in air, it is possible to further increase the numerical aperture of the projection optical system PL, and resolution improves on this point as well.

In each of the above described embodiments, an optical element LS1 is attached to the front end of the projection optical system PL, and this lens can be used to adjust the optical characteristics, aberration (spherical aberration, comatic aberration, for example) of the projection optical system PL. Note that the optical element attached to the front end of the projection optical system PL may be an optical plate used for adjusting the optical characteristics of the projection optical system PL. Alternatively, it may be a plane-parallel plate (cover glass or the like) through which exposure light EL can transmits.

When there is a large pressure between the substrate P and the optical element at the front end of the projection optical system PL generated by the flow of the liquid LQ, the optical element is not rendered exchangeable, but rather may be fixed firmly in place using this pressure so that the optical element does not move. Note that the design of the immersion mechanism 1 of the first nozzle member 70 is not limited to the structure described above. Rather, for example, it is also possible to employ a design such as disclosed in EU Patent Application, Publication No. 1420298, PCT International Patent Publication No. WO 2004/055803, PCT International Patent Publication No. WO 2004/057590, and PCT International Patent Publication No. WO 2005/029559.

Note that in the above embodiments, the space between the projection optical system PL and the surface of the substrate P is filled with a liquid LQ. However, it is also acceptable to fill this space with a liquid LQ, in an arrangement such that a glass plate consisting of a flat plate is attached to the surface of the substrate P.

In the projection optical system in the above embodiment, the optical path space on the image plane side of the front optical element is filled with liquid. However, as disclosed in PCT International Patent Publication No. WO 2004/019128, a projection optical system in which the optical path space on the image plane side (mask side) of the front optical element can also be filled with liquid.

Note that the liquid LQ of the above embodiments is water (pure water), but it may be a liquid other than water. For example, if the light source of the exposure light EL is an F₂ laser, this F₂ laser light will not pass through water, so the liquid LQ may be, for example, a fluorocarbon fluid such as a perfluoropolyether (PFPE) or a fluorocarbon oil that an F₂ laser is able to pass through. In addition, it is also possible to use, as the liquid LQ, liquids that have the transmittance with respect to the exposure light EL and whose refractive index are as high as possible and that are stable with respect to the photoresist coated on the projection optical system PL and the surface of the substrate P (for example, cedar oil). A variety of liquids LQ, for example a supercritical fluid may be employed as the liquid LQ.

Note that in the above described embodiments, the first immersion mechanism 1 and the second immersion mechanism 2 use the same liquid LQ. However, it is not necessary that the same liquid employed be the same, rather, the use of different liquids is acceptable. In addition, in the above embodiments, it is preferable that the second immersion mechanism 2 supply liquid LQ having the same temperature as that of the measuring members formed on the immersion region LR2. In this way, thermal deformation of the measuring members due to a temperature difference with the liquid LQ can be prevented. In addition, it is desirable that the first immersion mechanism 1 form an immersion region LR1 by supplying a liquid LQ having a temperature that is approximately the same as that of the substrate P. In this way, thermal deformation of the measuring members due to a temperature difference with the liquid LQ can be prevented.

In the abovementioned embodiments, respective position information for the mask stage MST, the substrate stage ST1, and measurement stage ST2 is measured using an interference system (52, 54, 56). However the invention is not limited to this and for example, an encoder system which detects a scale (grating) provided in each stage may be used. In this case, preferably a hybrid system is furnished with both of an interference system and an encoder system, and calibration of the measurement results of the encoder system is performed using the measurement results of the interference system. Moreover, position control of the stage may be performed using the interference system and the encoder system interchangeably, or using both.

Moreover as the liquid LQ, a liquid with a refractive index of 1.6 to 1.8 may be used. Furthermore, the optical element LS1 may be formed from a quartz, or a material with a higher refractive index than that of quartz (for example, above 1.6).

It is to be noted that as for substrate P of each of the above-described embodiments, not only a semiconductor wafer for manufacturing a semiconductor device, but also a glass substrate for a display device, a ceramic wafer for a thin film magnetic head, or a master mask or reticle (synthetic quartz or silicon wafer), etc. can be used.

As for exposure apparatus EX, in addition to a scan type exposure apparatus (scanning stepper) in which while synchronously moving the mask M and the substrate P, the pattern of the mask M is scan-exposed, a step-and-repeat type projection exposure apparatus (stepper) in which the pattern of the mask M is exposed at one time in the condition that the mask M and the substrate P are stationary, and the substrate P is successively moved stepwise can be used.

Furthermore, as the exposure apparatus EX, the present invention can also be applied to a twin stage type exposure apparatus furnished with a plurality of substrate stages, as disclosed for example in Japanese Unexamined Patent Application, First Publication No. H10-163099, Japanese Unexamined Patent Application, First Publication No. H10-214783 (corresponding to U.S. Patent No. 6,590,634), Published Japanese Translation No. 2000-505958 of PCT International Application (corresponding to U.S. Patent No. 5,969,411), and U.S. Patent No. 6,208,407. In this case, a measurement stage that is capable of independent movement may be mounted separately from the plurality of substrate stages holding a substrate. An immersion region LR2 identical to those of the above described embodiments may be formed onto the measuring member that is wet from contact with the immersion region LR1 on at least one of the plurality of substrate stages.

Note that in the above described embodiments, the exposure apparatus EX is provided with one or more of a substrate stage ST1 and a measurement stage ST2, and was designed such that at least an immersion region LR2 is formed on a measuring member that is in contact and wet by the liquid LQ of the immersion region LR1 formed on the measurement stage ST2. However, the exposure apparatus EX is not limited thereto. Rather, it is also acceptable to form an immersion region LR2 in the same manner as in the above described embodiments on to a measuring member that is in contact with and wet from the liquid LQ of the immersion region LR1 on only one substrate stage ST2.

In addition, the above described embodiments employ a stage (ST2) capable of two-dimensional movement for the movable member having the measuring members that supports (holds) the immersion region LR1 in place of the substrate stage ST1. However, the present invention is not limited thereto. For example, it is also acceptable to use a stage capable of movement in one dimension only, or, alternatively, a slide or rotating member may be employed.

Note that while in the above described embodiments the exposure apparatus EX is provided with a measurement stage ST2 for the movable component having measuring members, it is not absolutely essential to provide the measurement stage ST2. For example, an exposure apparatus that is provided with only a plurality of substrate stages, at least one of which has measuring members, may be suitably employed in the present invention. In this case, the immersion region LR2 may be formed in the same way as in the above described embodiments to the measuring members that are in contact with and wet from the liquid LQ of the immersion region LR1 on the substrate stage ST1.

In addition, a plurality of measuring members (reference mark plate FM and spatial image measuring sensor 60, etc.) are provided to the movable member (measuring stage, substrate stage, etc.) in the above described embodiments. Note, however, that the number and type of measuring members is not limited thereto, but rather, may be optionally selected. Further, the number of reference marks formed on the reference mark plate FM is not restricted, and may be just one, or at least one reference mark may be formed to each of a plurality of reference mark plates. It is also acceptable to form a reference mark directly to the movable member and not to the reference mark plate.

Moreover, as for the exposure apparatus EX, the present invention can be applied to an exposure apparatus of a method in which a reduced image of a first pattern is exposed in a batch on the substrate P by using the projection optical system (for example, a refractive projection optical system having, for example, a reduction magnification of 1/8, which does not include a reflecting element), in the state with the first pattern and the substrate P being substantially stationary. In this case, the present invention can be also applied to a stitch type batch exposure apparatus in which after the reduced image of the first pattern is exposed in a batch, a reduced image of a second pattern is exposed in a batch on the substrate P, partially overlapped on the first pattern by using the projection optical system, in the state with the second pattern and the substrate P being substantially stationary. As the stitch type exposure apparatus, a step-and-stitch type exposure apparatus in which at least two patterns are transferred onto the substrate P in a partially overlapping manner, and the substrate P is sequentially moved can be used.

Moreover, in the above embodiment, an exposure apparatus furnished with a projection optical system PL was described an example, however the present invention can also be applied to an exposure apparatus and an exposure method which does not use a projection optical system PL. Even in the case where a projection optical system PL is not used, the exposure light can be shone onto the substrate via optical members such as a mask and lens, and an immersion region can be formed in a predetermined space between these optical elements and the substrate.

The types of exposure apparatuses EX are not limited to exposure apparatuses for semiconductor element manufacture that expose a semiconductor element pattern onto a substrate P, but are also widely applicable to exposure apparatuses for the manufacture of liquid crystal display elements and for the manufacture of displays, and exposure apparatuses for the manufacture of thin film magnetic heads, image pickup elements (CCD), micro machines, MEMS, DNA chips, and reticles or masks.

In the abovementioned embodiments, an optical transmission type mask formed with a predetermined shielding pattern (or phase pattern or dimming pattern) on an optical transmission substrate is used. However instead of this mask, for example as disclosed in U.S. Patent No. 6,778,257, an electronic mask (called a variable form mask; for example this includes a DMD (Digital Micro-mirror Device) as one type of non-radiative type image display element) for forming a transmission pattern or reflection pattern, or a light emitting pattern, based on electronic data of a pattern to be exposed may be used.

Furthermore the present invention can also be applied to an exposure apparatus (lithography system) which exposes a run-and-space pattern on a substrate P by forming interference fringes on the substrate P, as disclosed for example in PCT International Patent Publication No. WO 2001/035168. Moreover, the present invention can also be applied to an exposure apparatus as disclosed for example in Published Japanese Translation No. 2004-519850 (corresponding U.S. Patent No. 6,611,316), which combines patterns of two masks on a substrate via a projection optical system, and double exposes a single shot region on the substrate at substantially the same time, using a single scan exposure light.

As far as is permitted by the law of the countries specified or selected in this patent application, the disclosures in all of the Japanese Patent Publications and U.S. Patents related to exposure apparatuses and the like cited in the above respective embodiments and modified examples, are incorporated herein by reference.

As described above, the exposure apparatus EX of the embodiments of this application is manufactured by assembling various subsystems, including the respective constituent elements presented in the Scope of Patents Claims of the present application, so that the prescribed mechanical precision, electrical precision and optical precision can be maintained. To ensure these respective precisions, performed before and after this assembly are adjustments for achieving optical precision with respect to the various optical systems, adjustments for achieving mechanical precision with respect to the various mechanical systems, and adjustments for achieving electrical precision with respect to the various electrical systems. The process of assembly from the various subsystems to the exposure apparatus includes mechanical connections, electrical circuit wiring connections, air pressure circuit piping connections, etc. among the various subsystems. Obviously, before the process of assembly from these various subsystems to the exposure apparatus, there are the processes of individual assembly of the respective subsystems. When the process of assembly to the exposure apparatuses of the various subsystems has ended, overall assembly is performed, and the various precisions are ensured for the exposure apparatus as a whole. Note that it is preferable that the manufacture of the exposure apparatus be performed in a clean room in which the temperature, the degree of cleanliness, etc. are controlled.

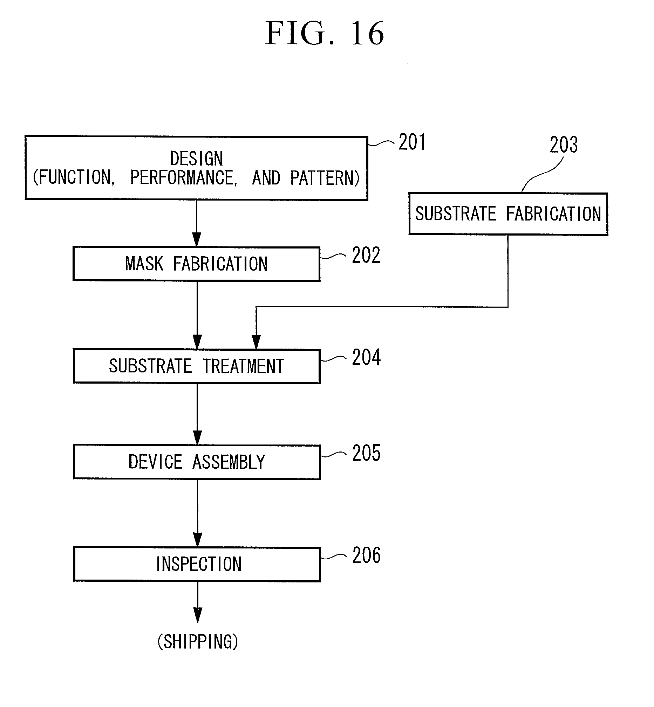

As shown in FIG. 16, microdevices such as semiconductor devices are manufactured by going through; a step 201 that performs microdevice function and performance design, a step 202 that creates the mask (reticle) based on this design step, a step 203 that manufactures the substrate that is the device base material, a step 204 including substrate processing step that exposes the pattern on the mask onto a substrate by means of the exposure apparatus EX of the aforementioned embodiments a device assembly step (including treatment processes such as a dicing process, a bonding process and a packaging process) 205, and an inspection step 206, and so on.

### [Industrial Applicability]

According to the present invention, it is possible to prevent the formation of water marks on or thermal deformation of measuring members. As a result, deterioration in the accuracy of measurements using the measuring members (i.e., deterioration in device performance) can be prevented, and exposure of a substrate can be carried out with good accuracy. In addition, the present invention is extremely useful in an exposure apparatus and method for manufacturing a wide range of product such as for example; semiconductor elements, liquid crystal display elements or displays, thin film magnetic heads, CCDs, micro machines, MEMS, DNA chips, and reticles (masks).

## Claims

1. An exposure apparatus that exposes a substrate via an optical member and a liquid, comprising:
a substrate holding member that is movable while holding the substrate;
a first immersion mechanism that fills a space between the optical member and the substrate holding member with a liquid;
a movable member that can be disposed in place of the substrate holding member at opposing the optical member while retaining with the optical member the liquid therebetween;
a measuring device that has a measuring member, which is disposed on the movable member, and that carries out a specific measurement when the measuring member is disposed opposite the optical member with the liquid held therebetween; and
a second immersion mechanism that forms an immersion region on the measuring member at least when the movable member has moved away from the optical member.

2. An exposure apparatus according to claim 1, wherein the second immersion mechanism has a liquid supply port that is disposed opposite the measuring member on the movable member when the movable member is located at a specific position separated from the optical member.

3. An exposure apparatus according to claim 2, wherein
the measuring member has a plurality of measurement patterns, and
the second immersion mechanism has a plurality of liquid supply ports that are respectively disposed opposite the plurality of measurement patterns when the movable member is at the specific position.

4. An exposure apparatus according to claim 2 or 3, wherein
a plurality of measuring members are disposed on the movable member, and
the second immersion mechanism has a plurality of liquid supply ports that are respectively disposed opposite the plurality of measuring members when the movable member is located at the specific position.

5. An exposure apparatus according to claim 1, wherein the measuring device has a plurality of measuring members on the movable member, and the second immersion mechanism forms an immersion region on at least the plurality of measuring members.

6. An exposure apparatus according to claim 5, wherein at least one of the measuring members has a measurement pattern.

7. An exposure apparatus according to claim 1, wherein the second immersion mechanism has a liquid supply port that is formed on the movable member, and forms an immersion region on a specific area on the moveable member that includes the measuring member.

8. An exposure apparatus according to claim 7, wherein the second immersion mechanism has a liquid collection port that is formed on the movable member so as to surround the measuring member and the liquid supply port.

9. An exposure apparatus according to claim 7, wherein the second immersion mechanism is formed on the movable member and has a recessed portion that can hold liquid, and the measuring member and the liquid supply port are disposed inside the recessed portion.

10. An exposure apparatus according to claim 1, wherein the second immersion mechanism is formed on the movable member and has a recessed portion that can hold liquid, and the measuring member is disposed inside the recessed portion.

11. An exposure apparatus according to any one of claims 1 to 10, wherein the measuring device receives exposure light via the liquid between the optical member and the measuring member, and via a light transmitting part formed in the measuring member, and the specific measurement is carries out.

12. An exposure apparatus according to any one of claims 1 to 11, wherein the second immersion mechanism forms an immersion region on the measuring member when the substrate holding member is disposed in place of the movable member at opposing the optical member.

13. An exposure apparatus according to any one of claims 1 to 12, wherein driving of the substrate holding member and driving of the movable member are carried out in parallel so that the immersion region formed by the first immersion mechanism is moved between on the substrate holding member and on the movable member while maintaining the immersion region with the optical member.

14. An exposure apparatus that exposes a substrate via an optical member and a liquid, comprising:
a first movable member that holds the substrate;
a first immersion mechanism that forms a first immersion region by filling a space between the optical member and the first movable member with a liquid;
a second movable member that can be disposed in place of the first movable member at opposing the optical member while retaining with the optical member the first immersion region therebetween, and that has a measuring member within the surface of contact with the liquid; and
a second immersion mechanism that forms a second immersion region on the measuring member that is in contact with the liquid at a different position from that of the first immersion mechanism.

15. An exposure apparatus according to claim 14, wherein the second immersion mechanism forms a second immersion region on the measuring member at least after maintenance of the first immersion region by the second movable member is released.

16. An exposure apparatus according to claim 14 or 15, wherein the second immersion mechanism forms a second immersion region on the measuring member when the first movable member is disposed in place of the second movable member at opposing the optical member while maintaining the first immersion region with the optical member.

17. An exposure apparatus according to any one of claims 14 to 16, wherein driving of the first movable member and driving of the second movable member are carried out in parallel so that the first immersion region is moved while being maintained with the optical member.

18. An exposure apparatus according to any one of claims 14 to 17, wherein surfaces of the first and the second movable members that are in contact with the liquid are set to have substantially the same height when the first immersion region is moving between the first and the second movable members.

19. An exposure apparatus according to one of any one of claims 14 to 18, wherein the measuring member includes at least one of a measurement pattern and a light transmitting part through which exposure light from the optical member and the liquid transmits.

20. A device manufacturing method that employs the exposure apparatus according to any one of claims 1 to 19.

21. An exposure method for exposing a substrate via an optical member and a liquid, the method comprising:
forming a first liquid immersion region by filling a space between the optical member and a first movable member that holds the substrate, with a liquid, and exposing the substrate via the optical member and the liquid;
disposing a second movable member in place of the first movable member at opposing the optical member while maintaining with the optical member the first immersion region therebetween; and
forming a second immersion region on top of the measuring member after the measuring member of the second movable member has come into contact with the liquid.

22. An exposure method according to claim 21, wherein the second immersion region is formed onto the measuring member at least after maintenance of the first immersion region by the second movable member is released.

23. An exposure method according to claim 21 or 22, wherein the second immersion region is formed on the measuring member when the first movable member is disposed in place of the second movable member at opposing the optical member while maintaining the first immersion region with the optical member.

24. An exposure method according to any one of claims 21 to 23, wherein driving of the first movable member and driving of the second movable member are carried out in parallel so that the first immersion region is moved while being maintained with the optical member.

25. An exposure method according to any one of claims 21 to 24, wherein the surfaces of the first and the second movable members that are in contact with the liquid are set to have substantially the same height when the first immersion region is moving between the first and the second movable members.

26. An exposure method according to any one of claims 21 to 25, wherein a specific measurement are carried out using the measuring member when the first immersion region is formed between the optical member and the second movable member.

27. An exposure method according to claim 26 where the measuring member is disposed inside the first immersion region during the specific measurements.

28. A device manufacturing method that uses an exposure method according to one of claims 21 to 27.
